# EUROPÄISCHE PATENTSCHRIFT

(11) **EP 0 710 432 B1**
(45) Veröffentlichungstag und Bekanntmachung des Hinweises auf die Patenterteilung: **02.01.2004**
(21) Anmeldenummer: 94914305.1
(22) Anmeldetag: 18.05.1994
(51) Int. Cl.: H05K 3/00, H05K 3/40, H01L 21/48

(54) **VERFAHREN ZUR HERSTELLUNG VON FOLIENLEITERPLATTEN ODER HALBZEUGEN FÜR FOLIENLEITERPLATTEN SOWIE NACH DEM VERFAHREN HERGESTELLTE FOLIENLEITERPLATTEN UND HALBZEUGE**
PROCESS FOR MANUFACTURING PRINTED CIRCUIT FOILS OR SEMIFINISHED PRODUCTS FOR PRINTED CIRCUIT FOILS, AND THUS MANUFACTURED PRINTED CIRCUIT FOILS AND SEMIFINISHED PRODUCTS
PROCEDE DE FABRICATION DE CIRCUITS IMPRIMES EN FEUILLES OU DE PRODUITS SEMI-FINIS DESTINES A LA FABRICATION DE CIRCUITS IMPRIMES EN FEUILLES, AINSI QUE CIRCUITS IMPRIMES EN FEUILLES ET PRODUITS SEMI-FINIS FABRIQUES SELON CE PROCEDE

(43) Veröffentlichungstag der Anmeldung: 08.05.1996
(73) Patentinhaber: Dyconex AG, 8303 Bassersdorf (CH)
(72) Erfinder: SCHMIDT, Walter, CH-8050 Zürich (CH); MARTINELLI, Marco, CH-8413 Neftenbach (CH)
(74) Vertreter: Frei, Alexandra Sarah
(86) Internationale Anmeldenummer: PCT/CH1994/000092
(87) Internationale Veröffentlichungsnummer: WO 1995/031883

(56) Entgegenhaltungen:
- WO-A-93/26143
- US-A- 4 711 791
- PATENT ABSTRACTS OF JAPAN vol. 16, no. 227 (E-1207) 26. Mai 1992 & JP,A,04 042 594 (DAINIPPON PRINTING CO) 13. Februar 1992

## Beschreibung

Die Erfindung liegt auf dem Gebiete der Herstellung von Leiterplatten und Folienleiterplatten und betrifft ein gemäss den Patentansprüchen definiertes Verfahren zur Herstellung von Leiterplatten, Folienleiterplatten und Halbzeugen für Leiterplatten und Folienleiterplatten, und sie betrifft nach dem Verfahren hergestellte Leiterplatten, Folienleiterplatten und Halbzeuge für Leiterplatten und Folienleiterplatten.

In vielen Anwendungsbereichen der modernen Elektrotechnik werden Schaltungsträger wie beispielsweise gedruckte Schaltungen mit integrierten Schaltungen (ICs) oder anderen aktiven und/oder passiven elektronischen Bauelementen mechanisch wie auch elektrisch miteinander verbunden. Dies geschieht üblicherweise mittels Steck- und Lötverbindungen. Die Anschlüsse der Bauelemente sind in vielen Fällen als Löt- oder Steckanschluss-Beinchen ausgeformt, über die die Bauelemente an der Leiterplatte oder Folienleiterplatte mechanisch fixiert und elektrisch mit diesen verbunden werden. Im zunehmenden Masse werden auch ungehäuste Bauelemente ("nackte" ICs) auf Leiterplatten oder Verbindungssubstrate direkt aufgebracht. Die elektrischen Verbindungen zwischen Bauelement und Verbindungssubstrat werden dabei entweder durch Drahtbonden, TAB (Tape-Automated-Bonding) oder durch Flip-Chip-Methoden bewerkstelligt. Diese Montagetechniken gewinnen heute - bedingt durch die stetig steigende Komplexität der elektronischen Funktionen - sehr an Bedeutung, da mit ihnen Platzgewinne und Kostenersparnisse erzielt werden können.

Meist werden aber solche Schaltungen in Form von Modulbausteinen konzipiert, welche im Prinzip höher integrierte Bauelemente darstellen. Solche Module müssen aber wiederum mit einer Leiterplatte oder Folienleiterplatte mechanisch und elektronisch verbunden werden, wodurch der Modulbaustein wiederum Anschlussbeinchen benötigt. Solche können in verschiedenster Art konstruktiv geformt sein, meist jedoch werden sie als vorgefertigte, kammartig strukturierte Beinchen aufgebracht, und so mit der Schaltung verlötet.

Schaltungen in Folienleiterplatten werden bekanntlich oft im Sinne von Flachbandkabeln verwendet, können ebenfalls analog zu den oben beschriebenen Verfahren mit Anschlussbeinchen versehen werden, meist jedoch werden Stecker aufgelötet, die ihrerseits wiederum mit Gegensteckern elektrisch und mechanisch verbunden werden können. Kennzeichnend für solche Verbindungen ist, dass ein erstes Element (Modulbaustein, Leiterplatte oder Folienleiterplatte) und ein zweites Element (Leiterplatte oder Folienleiterplatte, etc.) mechanisch und elektrisch miteinander verbunden werden müssen. Dies bedeutet, dass für die Herstellung einer elektrischen Verbindung eines einzigen Strompfads zwei elektrische Verbindungstellen nötig sind, was nicht nur Kosten verursacht, sondern auch einen negativen Einfluss auf die Zuverlässigkeit hat. Zudem kann die Verbindungsstelle nicht optimal ausgenutzt werden. Das Leiterbild, die Gesamtheit der Strompfade, Isolierbereiche, Öffnungen und Durchplattierungen muss für ihre Anbringung angepasst werden. Beispielsweise werden Strompfade im Bereich der Anbringung der Verbindungsmittel mechanisch verstärkt oder in ihrer physikalischen Ausdehnung modifiziert. Anschlussbeinchen werden aus montagetechnischen Gründen oft wesentlich dicker als notwendig gearbeitet. Lötaugen werden meistens breiter als die an sie herangeführten Strompfade, usw. angelegt. Diese Vorkehrungen erfordern Verfahren mit teilweise komplizierten Verarbeitungsschritten, sie beanspruchen Zeit und Platz.

Schaltungen mit komplexeren Konturen werden gemäss dem Stande der Technik aus Material und mit bekannten Apparaturen für einzelne Schritte bekannter Herstellungsverfahren hergestellt, sodass diese Schaltungen gut manipulierbare Formen haben, das heisst bei Leiterplatten üblicherweise aus rechteckigen oder quadratischen Materialstücken sind oder bei Folienleiterplatten quasi endloses Material ab Rolle ist. Erst in einem der letzten Arbeitsschritte werden die Schaltungen dann entsprechend ihrer definitiven Konturen aus dem Substrat herausgefräst oder herausgestanzt. Dieser Endzuschnitt setzt der Komplexität der Konturen ihre Grenzen. Je komplexer die Form und je kleiner einzelne Abmessungen der zu erstellenden Leiterplatten und Folienleiterplatten sind, desto schwieriger und aufwendiger wird der Endzuschnitt.

Bei kleineren Stückzahlen, bei denen sich die Herstellung von Stanzwerkzeugen nicht lohnt, erfolgt ein Herausschneiden durch Fräsen. Soll dünnes Folienmaterial gefräst werden, muss es, um ein Ausweichen vor dem Werkzeugdruck zu verhindern, zwischen starren Trägermaterialien eingeklemmt werden. Die Trägermaterialien werden mitgefräst und stellen ein teures Hilfsmaterial dar. Trotz der verwendeten Trägermaterialien ist die Genauigkeit des Frässchrittes limitiert und insbesondere können keine sehr schmalen Bereiche ausgefräst werden, da das Fräsen ein sequentieller Vorgang ist und das Ausweichen des Materials stärker wird, wenn nacheinander nahe beieinander liegende Frässchnitte erzeugt werden. Ein weiteres Problem ist das Ausfransen der Fräsränder, was in teurer, manueller Nacharbeit erfolgt.

Für grössere Stückzahlen erfolgt vorteilhafterweise ein Stanzen. Das Werkzeug für einen derartigen Stanzschritt kann beispielsweise ein in einer Ausfräsung einer Basisplatte eingelegtes, messerförmig geschliffenes flexibeles Stahlband sein, sodass sich beliebig geformte Ausfräsungen erzeugen lassen. Allerdings sind Krümmungsradien kleiner als ca. 3 mm kaum realisierbar. Auch liegen die Standzeiten derartiger Werkzeuge bei etwa 1000 Hüben und die Schnittgenauigkeit beträgt höchstens ±0,2 mm. Bessere Stanzgenauigkeiten können mit Werkzeugen aus härtbarem Stahl erreicht werden. Solche Werkzeuge werden durch Funkenerosion hergestellt, die ihrerseits noch bedeutend teurer als die oben erwähnten Stanzwerkzeuge aus Stahlband sind. In jedem Falle ist eine aufwendige Stanzmaschine notwendig, wodurch der Endzuschnitt von Schaltungen mittels Stanzen sehr aufwendige ist.

Die Zusammenfassung der japanischen Offenlegungsschrift 4042594 offenbart ein Verfahren zum Erzeugen von Durchführungslöchem in Leiterplatten, wobei gleichzeitig Rillen als Sollbruchstellen zur späteren Abtrennung von Teilstücken der Leiterplatten erzeugt werden.

Es wäre wünschenswert die Anbringung von mechanischen Strukturierungen für Verbindungsmittel und auch komplizierte Konturen wie Anschlussbeinchen, Stecker, Lötaugen, Löcher, Rillen, usw. derart in Leiterplatten und Folienleiterplatten zu integrieren, dass der hierfür benötigte Aufwand und Platzverbrauch minimal gehalten wird. Hierbei sollen bekannte und bewährte Verarbeitungsschritte und entsprechende Werkzeuge und Apparaturen anwendbar sein.

Es ist Aufgabe der vorliegenden Erfindung, ein Verfahren zur Herstellung von Leiterplatten, Folienleiterplatten und Halbzeugen für Leiterplatten und Folienleiterplatten aufzuzeigen, wonach die Herstellung von Strukturierungen für Verbindungsmittel und Konturen schon bei der Herstellung der Leitemlatten und Folienleiterplatten in das Substrat dieser Leiterplatten und Folienleiterplatten integriert werden und nicht nachträglich angebracht werden müssen.

Die Aufgabe wird durch die in den Patentansprüchen aufgezeigte Erfindung gelöst.

Die Erfindung beruht auf der Beobachtung, dass sich in Isolatorschichten und Substraten von Leiterplatten und Folienleiterplatten mittels Plasma-Ätzen nicht nur einfache Strukturen wie Sacklöcher oder Durchgangslöcher, sondern dass sich auch komplizierte Strukturen anbringen lassen. Hieraus ergeben sich neue Freiheitsgrade im Entwurf von Leiterplatten und Folienleiterplatten.

Diese Neuerung ist die Integration der Herstellung von funktional nach aussen gerichteten Verbindungsmitteln und von Konturen um Leiterbilder im Substrat in die Herstellung der Leiterbilder oder internen Strukturen der Leiterplatten und Folienleiterplatten. Die Verbindungsmittel dienen beispielsweise zur Stromversorgung, zur Verbindung mit anderen Schaltungen oder zur Verbindung mit anderen Bereichen des gleichen Leiterbildes und die Konturen dienen als vorgefertigte Bruchstellen zum Heraustrennen von Leiterbildern aus dem Substrat. Es liegt also eine Integration von Verbindungsmitteln und von Konturen im oder am Substrat in die Strukturierung des Leiterbildes vor und betrifft die Strukturierung von Strompfaden, Isolatorbereichen, Öffnungen, Durchplattierungen, Stegen, Rillen, usw.

Im erfindungsgemässen Verfahren werden Gebilde von dreidimensionaler Struktur wie Anschlussbeinchen, passend dazu gearbeitete Anschlussöffnungen mit Strompfaden, flexible Anschlussbeinchen und abgeschirmte Kabel als Verbindungsmittel und Öffnungen, Stege und Rillen als Konturenlinien bei der photochemischen Strukturierung der Leiterplatten, Folienleiterplatten und ihrer Halbzeuge hergestellt. Im Sinne eines vorteilhaften, dichtesten flächendeckenden Leiterbildes werden die Verbindungsmittel und Konturen hierzu derart in die Herstellung des Leiterbildes miteinbezogen, dass sie gleichzeitig oder in gleichen Verfahren und nach gleichen oder ähnlichen Masken wie dieser aus Vorprodukten hergestellt werden.

Die Verbindungsmittel und Konturen werden fest im oder am Substrat angebracht gearbeitet. Sie müssen somit nicht mehr nachträglich auf den fertigen Leiterplatten oder Folienleiterplatten angebracht werden, sondern sind schon bei deren Herstellung Teile derselben. Der Unterschied zwischen Verbindungsmitteln und Konturen besteht nun darin, dass Verbindungsmittel mit elektrisch leitenden Lagen beschichtet sind und nur partiell vom Substrat gelöst werden, während Konturen elektrisch isolierend sind und ein vollständiges Lösen fertiger Leiterbilder aus dem Substrat erlauben.

Verbindungsmittel sind also partiel vom Substrat lösbar und räumlich orientierbar und erfüllen so verbindende Funktionen. Sie sind mit herangeführten Strompfaden versehen und müssen aus montagetechnischen Gründen mechanisch nicht mehr verstärkt oder in ihrer Ausdehnung modifiziert werden.

Konturen sind im Substrat bereits in quasi fertigem Zustand enthalten, d.h. sie sind als vollständig trennbare Konturlinie angeordnet. Solche Konturöffnungen werden durch Verbindungsstege voneinander getrennt und reichen durch die ganze Dicke des Substrats. Abschliessend genügt es, Verbindungsstege durchzutrennen, was bei entsprechender Anordnung der Stege mit wenig Präzision beispielsweise mit einer Schere von Hand durchgeführt werden kann. Dies ist möglich, wenn die Verbindungsstege sehr schmal sind und an Positionen vorgesehen sind, an denen auf die höchste Präzision verzichtet werden kann. Durch die Verbindungsstege bleiben die entstehenden Leiterbilder auch nach dem Erstellen der Konturöffnungen untereinander oder mit Restmaterial verbunden und die einfach manipulierbare Form des Materials an sich bleibt dadurch bis zum Abschluss des Verfahrens erhalten.

Das erfindungsgemässe Verfahren besteht darin, die Leiterbilder aus einer oder mehreren Lagen von Folienmaterial als Vorprodukte aufzubauen, wobei das Folienmaterial stückig oder quasi endlos ist. Entsprechende Verfahren sind in den CH-Patentanmeldungen Nr. 1872/92 und 987/93 derselben Anmelderin beschrieben. Die Strukturierungen wie schaltungsrelevante Öffnungen und Konturöffnungen werden in gleichen Verfahren erstellt.

Derartig hergestellte Leiterbilder sind über ihre ganze Fläche dünn und flexibel, das heisst sie können aus einer oder wenigen übereinanderliegenden Folienlagen bestehen, sie können aber auch starre Bereiche aufweisen, an denen die Anzahl aufeinanderliegender Folienlagen gegenüber flexiblen Bereichen grösser ist, oder sie können auch bereichsweise durch entsprechend geformte Trägerelemente versteift sein, beispielsweise indem eine Folienleiterplatte darauf aufgezogen wird.

Bei gewissen Ausführungsformen und Verfahrensvarianten besitzen die Leiterbilder flexible Randbereiche, über die eine Mehrzahl von Leiterbahnen oder Strompfade im wesentlichen parallel zueinander gegen den Rand hin verlaufen. Da, wo die Leiterbahnen den Rand der Leiterbilder erreichen, ist der Rand nicht geradlinig gearbeitet, sondern weist schlitzförmige Öffungen oder Einformungen auf, die sich zwischen den Leiterbahnen erstrecken, derart, dass die äussersten Enden der Leiterbahnen je einzeln auf einer entsprechenden, lippenförmigen Ausformung liegen. Die schlitzförmigen Öffnungen zwischen den zu verlötenden Leiterbahnenden verhindern ein leichtes Verfliessen des Lotes, sodass die Leiterbahnen näher beieinander liegen können und das Verfliessen des Lotes keine Probleme verursacht.

Anhand der nachfolgend aufgeführten Figuren 1 bis 45 wird das erfindungsgemässe Verfahren näher erläutert.
- **Fig.1**: zeigt perspektivisch einen Teil einer beispielhaften Ausführungsform eines auf Leiterplatten und Folienleiterplatten bestückbaren Schaltungsträgers.
- **Fig.2**: zeigt in Ansicht einen Teil einer beispielhaften Ausführungsform eines Flachbandkabels.
- **Fig.3**: zeigt perspektivisch einen Teil einer ersten Ausführungsform eines Verbindungsmittels in Form eines flexiblen Anschlussbeinchens.
- **Fig.4**: zeigt perspektivisch einen Teil einer zweiten Ausführungsform eines Verbindungsmittels in Form eines Arrays kontaktierbarer Anschlussbeinchen.
- **Fig.5**: zeigt perspektivisch einen Teil einer dritten Ausführungsform eines Verbindungsmittels in Form eines Arrays kontaktierbarer Anschlussbeinchen.
- **Fig.6-16**: zeigen eine erste Variante des erfindungsgemässen Verfahrens der photochemischen Strukturierung von Verbindungsmitteln wie Anschlussöffnungen mit herangeführten Strompfaden.
- **Fig.17**: zeigt eine zweite Variante des erfindungsgemässen Verfahrens der photochemischen Strukturierung von Verbindungsmitteln wie Anschlussbeinchen.
- **Fig.18-23**: zeigen eine dritte Variante des erfindungsgemässen Verfahrens der photochemischen Strukturierung von Verbindungsmitteln wie Anschlussöffnungen mit herangeführten Strompfaden.
- **Fig.24**: zeigt eine vierte Variante des erfindungsgemässen Verfahrens der photochemischen Strukturierung von Verbindungsmitteln wie Anschlussbeinchen.
- **Fig.25-32**: zeigen eine fünfte Variante des erfindungsgemässen Verfahrens der photochemischen Strukturierung von Verbindungsmitteln wie eines abgeschirmten Kabels.
- **Fig.33-34**: zeigen in Draufsicht und Seitensicht eine weitere Ausführungsform einer Leiterplatte oder Folienleiterplatte mit Verbindungsmitteln in Form eines Schaltungsträgers wie ein Multi-Chip-Modul (MCM).
- **Fig.35-36**: zeigen Details aus dem Randbereich des Multi-Chip-Moduls gemäss den Figuren 33 und 34 in einem grösseren Massstab.
- **Fig.37**: zeigt in Draufsicht eine erste beispielhafte Ausführungsform von komplexen Konturen in Leiterplatten und Folienleiterplatten oder entsprechendem Halbzeug zur Herstellung derselben.
- **Fig.38-40**: zeigen drei Stadien einer beispielhaften Verfahrensvariante zur Herstellung solcher Konturen gemäss Figur 37 aus einer einzigen Folienlage (Querschnitte).
- **Fig.41-44**: zeigen vier Stadien einer weiteren beispielhaften Verfahrensvariante zur Herstellung solcher Konturen gemäss Figur 37 (Querschnitte).
- **Fig.45**: zeigt ein Verfahrensstadium gemäss Figur 44 für Leiterplatten und Folienleiterplatten oder Halbzeuge zur Herstellung derselben bestehend aus mehreren Folienlagen (Querschnitt).

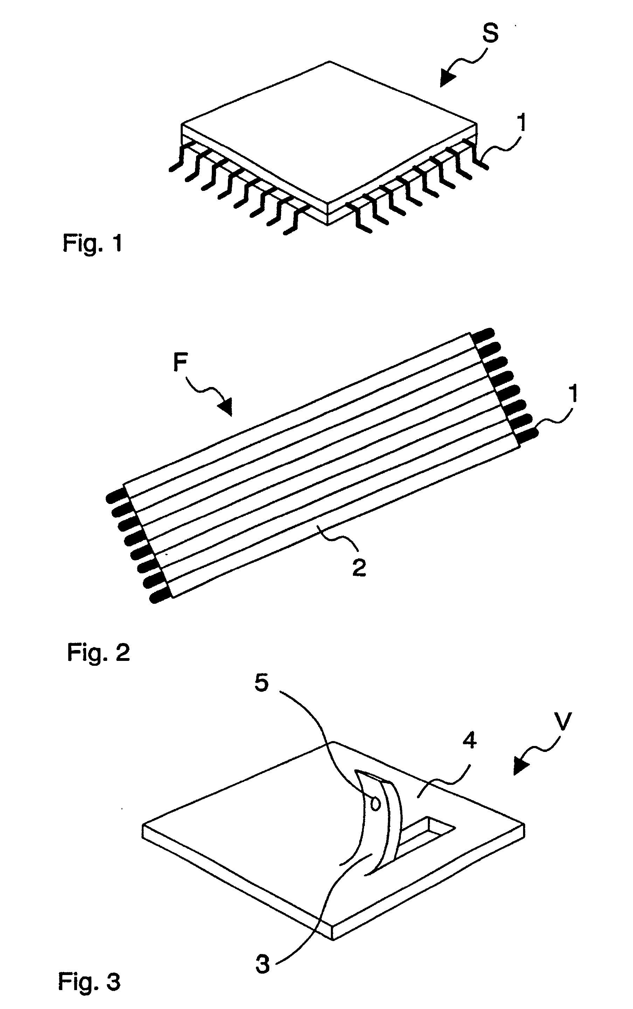

**Figur 1** zeigt perspektivisch einen Teil einer beispielhaften Ausführungsform eines auf Leiterplatten und Folienleiterplatten bestückbaren Schaltungsträgers. Solche Schaltungsträger S können beispielsweise Single-Chip-Modules (SCMs) oder Multi-Chip-Modules (MCMs) sein, deren integrierte Schaltung zum Schutz vor mechanischen Beschädigungen und vor schädlichen Umwelteinflüssen in ein Gehäuse eingebaut ist. Die auf dem Verbindungssubstrat des Chips oder im Gehäuse fest angebrachten Anschlussbeinchen 1 sind mit Löchern oder Lötflächen von Leiterplatten und Folienleiterplatten steckbar oder verlötbar. Sie sind meistens aus Metall wie Kupfer und vergoldetem Kupfer gearbeitet und haben typische Durchmesser von 0,3 bis 1 mm und Längen von 3 bis 10 mm. Die Anschlussbeinchen 1 sind oft in regelmässigen Abständen von 0,3 bis 2,54 mm - je nach Rastemass des Bausteins - an seitlichen Begrenzungen der Schaltungsträger S angebracht. Ihre Gegenstücke, die Löcher oder Lötflächen von Leiterplatten und Folienleiterplatten bilden entsprechende Anordnungen von ähnlicher Geometrie.

**Figur 2** zeigt in Ansicht einen Teil einer beispielhaften Ausführungsform eines Flachbandkabels. Die Adern des Flachbandkabels F sind von einer elektrisch isolierenden Schutzschicht 2 ummantelt, die Enden des Flachbandkabels liegen frei und bilden steckbare oder lötbare Anschlussbeinchen 1. Die Schutzschicht 2 kann elektromagnetisch abgeschirmt sein, um so störungsfrei, hochfrequente Anwendungen zu ermöglichen.

**Figur 3** zeigt perspektivisch einen Teil einer ersten Ausführungsform eines im erfindungsgemässen Verfahren hergestellten Verbindungsmittels V in Form eines einzelnen flexiblen Anschlussbeinchens 3. Wie weiter unten im Detail beschrieben wird, lassen sich solche flexiblen Anschlussbeinchen 3 in Isolatorschichten oder Substraten 4 herstellen, indem solche Isolatorschichten 4 mittels Plasma-Ätzen an der Position den späteren Umrandungen der flexiblen Anschlussbeinchen 3 durchgeätzt werden. Das Anschlussbeinchen 3 in der Ausführungsform gemäss Figur 3 ist von rechteckiger Gestalt, es wurde durch durchgehendes Ätzen von drei miteinander verbundenen Seiten eines Rechtecks aus der Isolatorschicht 4 quasi herausgeschnitten. Mit der vierten Seite des Rechtecks ist es aber fest mit dem Substrat 4 verbunden. Die Geschwindigkeit dieses Ätz-Vorgangs hängt von der Dicke der Isolatorschicht 4 ab und beträgt bei Isolatorschichten 4 in Form dünner Polyimidfolien von 25 bis 50 µm Dicke einige Minuten. Die Flexibilität solcher Anschlussbeinchen 3 hängt von der Eigensteifigkeit des verwendeten Isolatormaterials und weiteren Verfahrensschritten wie Metallisieren ab. Je nach Stärke dieser Flexibilität kann das Anschlussbeinchen 3 durch entsprechende Instrumente vorgebogen und aus der Ebene des flachen Substrats 4 herausgebogen werden, um dann in dieser vorgeformten Ausrichtung für weitere Verwendungszwecke in späteren Verfahrensschritten zu verharren. Das Anschlussbeinchen 3 weist an seinem vorderen Ende ein ebenfalls plasma-geätztes Durchgangsloch 5 auf, worüber es sich an dafür passende Verbindungsmittel V, wie beispielsweise einen Stift mechanisch befestigen lässt. Ist das Anschlussbeinchen 3 mit Strompfaden versehen, so lässt es sich über das Durchgangsloch 5 auch als elektrischer oder elektronischer Leiter steckbar oder dauerhaft verbinden.

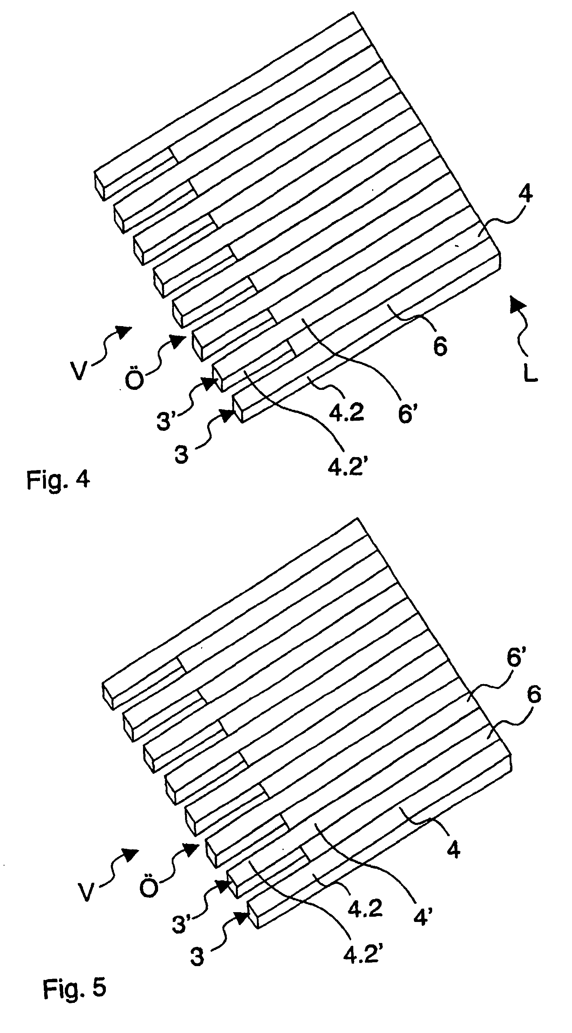

**Figur 4** zeigt perspektivisch einen Teil einer zweiten Ausführungsform eines im erfindungsgemässen Verfahren hergestellten Verbindungsmittels V in Form eines Arrays kontaktierbarer Anschlussbeinchen. Bei dieser Ausführungsforni wird an einer äusseren Begrenzung eines Substrats 4 von Leiterplatten und Folienleiterplatten ein regelmässiges Array von Öffnungen Ö in Form kleiner rechteckiger Einschnitte durch Plasma-Ätzen entfernt. Die zwischen diesen Öffnungen Ö seitlich herausragenden Substratenden 4.2,4.2' sind mit herangeführten Strompfaden 6,6' gearbeitet und bilden Anschlussbeinchen 3,3'. Die herangeführten Strompfade 6,6' sind im Bereich der Ausformung der Anschlussbeinchen 3,3' mechanisch nicht verstärkt oder in ihrer räumlichen Ausdehnung modifiziert. Die Anschlussbeinchen 3,3' sind an ihrem einen Ende fest mit dem Substrat 4 verbunden und liegen ansonsten frei und bilden steckbare oder lötbare Verbindungsmittel V mit entsprechend gearbeiteten Löchern oder Lötaugen von Leiterplatten und Folienleiterplatten. Wie weiter unten im Detail gezeigt wird, findet die Herstellung der Anschlussbeinchen 3,3' gleichzeitig und im gleichen Verfahren wie die photochemische Strukturierung aller Strompfade 6,6' der Leiterplatten oder Folienleiterplatten statt. Um ein vorteilhaftes, dichtestes flächendeckendes Leiterbild L zu realisieren, sind die Strompfade 3,3' derart in den Schaltungsentwurf miteinbezogen, dass sie sich gleichzeitig oder in gleichen Verfahren und nach gleichen oder ähnlichen Masken herstellen lassen.

**Figur 5** zeigt perspektivisch einen Teil einer dritten Ausführungsform eines im erfindungsgemässen Verfahren hergestellten Verbindungsmittels V in Form eines Arrays kontaktierbarer Anschlussbeinchen. Diese Ausführungsform ist mit derjenigen gemäss Figur 4 weitgehend identisch, ausser, dass die Strompfade 6,6' jetzt nicht bis auf die herausragenden Substratenden 4.2,4.2' reichen und auch nicht in deren Verlängerungachse verlaufen, sondern in der Verlängerungachse der Öffnungen Ö verlaufen und an diese anstossend gearbeitet sind.

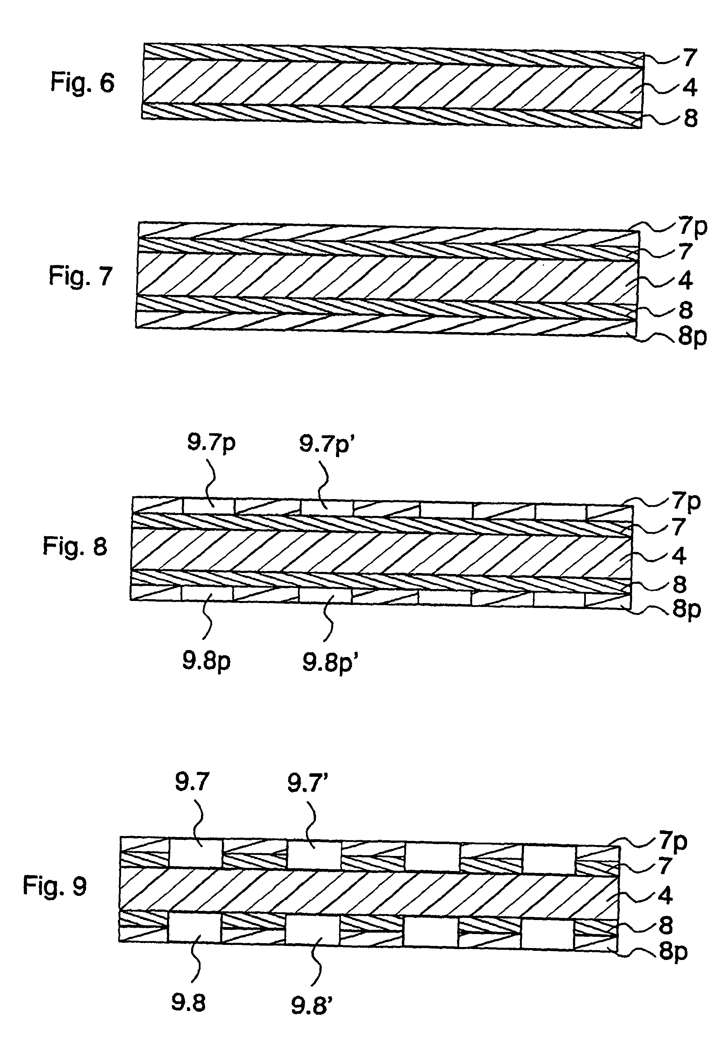

In den **Figuren 6** bis **16** wird eine erste Variante des erfindungsgemässen Verfahrens der photochemischen Strukturierung von Verbindungsmitteln V wie Anschlussöffnungen 11,11' mit herangeführten Strompfaden 6,6' durch Schnitte eines Teils eines Vorprodukts von Folienleiterplatten und Leiterplatten beschrieben. Ausgehend von einer dreilagigen Folie als Vorprodukt mit zwei Lagen elektrisch leitender Schichten (Metallschichten) 7,8 und einer Isolatorschicht oder Substrat 4 wird in einem photochemischen Verfahren die Strukturierung (Layout) der Schaltung und die von Öffnungen Ö mit herangeführten Strompfaden 6,6' vorgenommen. Natürlich lassen sich auch dünne mehrlagige Platten als Vorprodukte verwenden und es lassen sich auch drei- und mehrlagige Leiterplatten, Folienleiterplatten und Halbzeuge zur Herstellung derselben benutzen. Die Vorprodukte können flexibel sein.

In **Figur 6** sieht man einen Teil einer dünnen dreilagigen Folie bei der zwei elektrisch leitende Schichten oder Metallschichten 7,8 voneinander durch eine elektrisch isolierende Schicht 4 getrennt sind. Vorteilhafterweise werden dünne Metall/Isolatorschichten in Form von lediglich 25 bis 50 µm dicken Kupfer und Polyimid- oder Epoxyfolien verwendet.

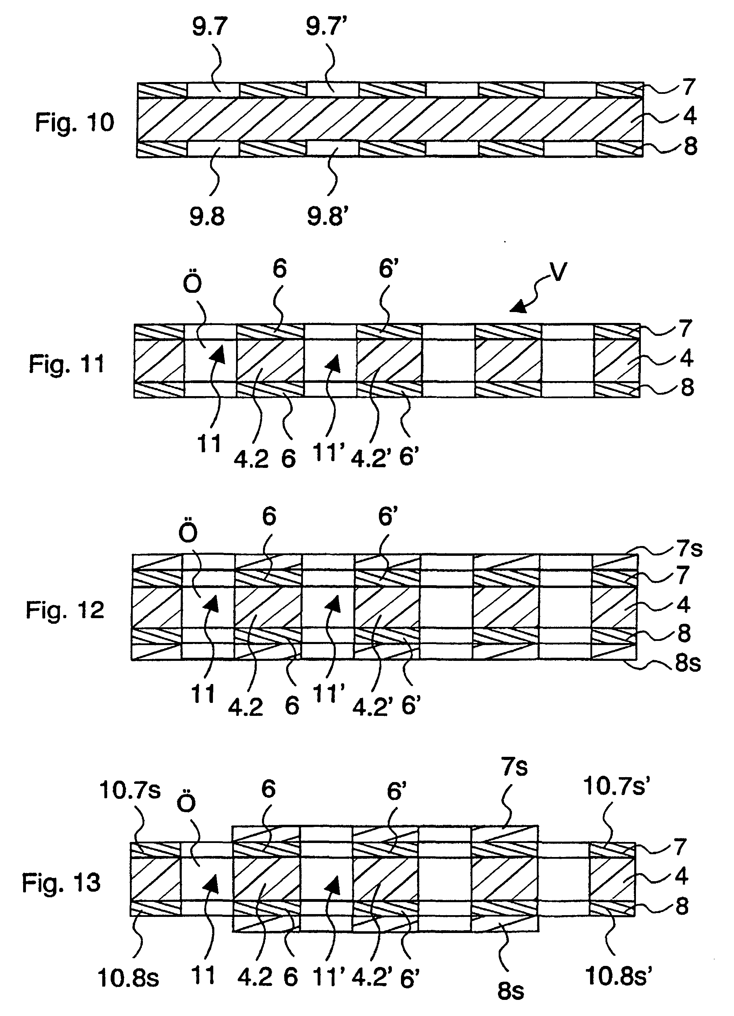

In **Figur 7** sieht man das Vorprodukt nach dem Auftragen zweier Photoresistschichten 7p,8p auf die leitenden Schichten 7,8, sodass diese vollständig mit Photoresisit bedeckt sind. Es kann festes oder flüssiges Photoresist verwendet werden. Die Schichten Photoresist 7p,8p können in bekannten photochemischen Verfahren belichtet werden und können so einen Schaltungsentwurf und einen Verbindungsmittelentwurf über Photomasken übertragen. Der Schaltungsentwurf beinhaltet Position und Struktur der herzustellenden Leiterbahnen oder Strompfade und Isolierbereiche in den Metallschichten 7,8. Der Verbindungsmittelentwurf beinhaltet Position und Struktur der herzustellenden Verbindungsmittel V. Diese Entwürfe wie Schaltungsentwurf und Verbindungsmittelentwurf sind aufeinander abgestimmt und ergänzen sich. In dieser ersten Variante des erfindungsgemässen Verfahrens werden in der ersten Strukturierung gemäss den Figuren 6 bis 11 nur die Verbindungsmittel realisiert, während die Strompfade in einer zweiten Strukturierung gemäss den Figuren 11 bis 15 gebildet werden.

In **Figur 8** sieht man die gemäss den Verbindungsmittel- und den Schaltungsentwürfen photochemisch durchgeführte Strukturierung der Schichten Photoresist 7p,8p. In den strukturierten Schichten Photoresist 7p und 8p werden Verbindungsmittelstrukturen 9.7p,9.7p' und 9.8p,9.8p' gebildet, welche bis auf die metallischen Schichten 7 und 8 herabreichen. Die anderen, mit Photoresist bedeckten Bereiche der Metallschichten 7,8 sind Schaltungsstrukturen, welche so bei der in weiteren Verfahrensschritten folgenden photochemischen Bearbeitung vor dem nasschemischen Ätzen geschützt werden. Die flächige Grösse der Verbindungsmittelstrukturen liegt im Millimeterbereich, und ist die Grössenordnung der herzustellenden Anschlussöffnungen. Technisch realisierbar sind auch wesentlich kleinere gearbeitete Strukturen in der Grössenordnung von 25 bis 100 µm. Die Formen der Flächen sind frei wählbar, sie können als kreiszylindrische, runde, ovale und auch quadratische, rechteckige, mehreckige Flächen ausgebildet werden.

In **Figur 9** sieht man die mit photochemisch strukturierten Schichten Photoresist 7p,8p bedeckten Metallschichten 7,8 nach erfolgtem nasschemischen Ätzen des von Photoresist unbedeckten Metalls der Metallschichten 7,8. Dieses Ätzen erfolgt gemäss dem Verbindungsmittelentwurf nur im Bereich der Verbindungsmittelstrukturen 9.7p,9.7p' und 9.8p,9.8p' und führt zur gezielten Bildung von Verbindungsmittelmündungen 9.7,9.7'und 9.8,9.8' welche bis auf die Isolatorschicht 4 hinabreichen. Es sei erwähnt, dass dieses nasschemische Ätzen generell auch mittels Aufpressen wiederverwendbarer Schablonen aus beispielsweise Edelstahlfolien geschehen kann. Solche Schablonen werden durch das Ätzmedium nicht angegriffen und das Ätzmedium kann nur in Bereichen von Öffnungen in diesen Schablonen an die zu ätzenden Metallschichten 7,8 gelangen.

In **Figur 10** sieht man das sich im Herstellungsstadium gemäss Figur 9 befindliche Vorprodukt nach Entfernen der Schichten Photoresist 7p und 8p. Dies geschieht mittels bekannter und bewährter chemischer Prozesse. Dieser Verfahrensschritt ist fakultativ, da je nach Art und Dauer des folgenden Plasma-Ätzens, der Photoresist beim Plasma-Ätzen durch die unbedeckte Isolatorschicht 4 mehr oder weniger vollständig entfernt wird.

In **Figur 11** sieht man das gemäss Figur 10 von Photoresist gesäuberte Vorprodukt nach dem Plasma-Ätzen von Verbindenden zwischen den Verbindungsmittelmündungen 9.7,9.7'und 9.8,9.8' durch die Isolatorsschicht 4 hindurch. Durch diese Verbindenden werden die Verbindungsmittelmündungen 9.7,9.7' und 9.8,9.8' der beiden Metallschichten 7,8 miteinander verbunden. Sie bilden so Verbindungsmittel V in Form von Anschlussöffnungen 11,11' mit an Öffnungen Ö herangeführten Strompfaden 6,6'. Die Strompfade 6,6' werden auf den durch Plasma-Ätzen strukturierten Substratenden 4.2,4.2' herangeführt.

**In Figur 12** sieht man das Vorprodukt nach dem Auftragen zweier weiterer Photoresistschichten 7s,8s auf die mit Öffnungen Ö versehenen leitenden Schichten 7,8. Die Metallschichten 7,8 können mit festem oder flüssigem Photoresist 7s,8s bedeckt und in bekannten photochemischen Verfahren belichtet werden, um so den Strompfadentwurf über Photomasken zu übertragen. Dieser Strompfadentwurf beinhaltet Position und Struktur weiterer herzustellender Strompfade und Isolatorbereiche in den Metallschichten 7,8.

In **Figur 13** sieht man die gemäss dem Strompfadentwurf photochemisch durchgeführte Strukturierung der Schichten Photoresist 7s,8s. In den strukturierten Schichten Photoresist 7s,8s werden Isolatorstrukturen 10.7s,10.7s' und 10.8s,10.8s' gebildet, welche bis auf die metallischen Schichten 7,8 herabreichen. Die anderen, mit Photoresist bedeckten Bereiche der Metallschichten 7,8 sind Strompfadstrukturen, welche so bei der in weiteren Verfahrensschritten folgenden photochemischen Bearbeitung vor nasschemischem Ätzen geschützt werden.

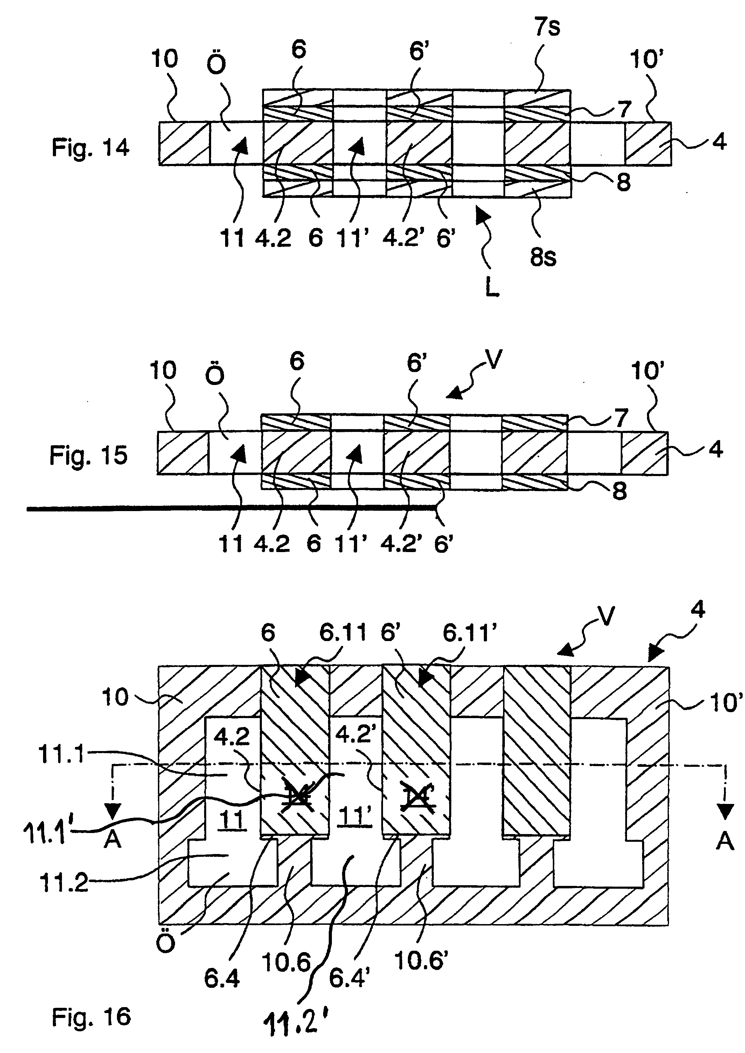

In **Figur 14** sieht man die mit photochemisch strukturierten Schichten Photoresist 7s,8s bedeckten Metallschichten 7,8 nach erfolgtem nasschemischen Ätzen des von Photoresist unbedeckten Metalls der Metallschichten 7,8. Dieses Ätzen erfolgt gemäss dem Strompfadentwurf nur im Bereich der mit Photoresist unbedeckten Isolatorstrukturen 10.7s,10.7s' und 10.8s,10.8s' und führt zur gezielten Bildung elektrisch nichtleitender Bereiche welche Isolatorbereiche 10,10' genannt werden und führt zur Bildung elektrisch leitender Bereiche, welche Strompfade 6,6' genannt werden. Die Isolatorbereiche 10,10' und Strompfade 6,6' sind Teile der so realisierten Schaltung/Leiterbildes, sie isolieren die in den strukturierten leitenden Schichten 7,8 verlaufenden Strompfade 6,6' gegeneinander.

In **Figur 15** sieht man das sich im Herstellungsstadium gemäss Figur 14 befindliche Vorprodukt nach Entfernen der restlichen Schichten Photoresist 7s,8s. Dies geschieht mittels bekannter und bewährter chemischer Prozesse. Die erste Variante des erfindungsgemässen Verfahrens zur Herstellung von Leiterplatten, Folienleiterplatten und Halbzeugen für Leiterplatten und Folienleiterplatten aus dem Vorprodukt gemäss Figur 6 mit einer vierten Ausführungsform eines Verbindungsmittels V in Form von Anschlussöffnungen 11,11' mit auf Substratenden 4.2,4.2' herangeführten Strompfaden 6,6' ist somit abgeschlossen.

In **Figur 16** sieht man in Draufsicht einen Teil einer Folienleiterplatte oder Leiterplatte, dessen Schnitt AA der Ansicht im Querschnitt gemäss Figur 15 entspricht. Die Öffnungen Ö und die Strompfade 6,6' werden durch das Substrat 4 gegeneinander getrennt, mechanisch getragen und elektrisch gegeneinander isoliert. Die Öffnungen Ö sind identisch gearbeitet und parallel zueinander angeordnet. Sie weisen eine längliche Struktur auf und besitzen in der gezeigten Ausführungsform unterschiedlich breite Enden. Erfindungsgemäss kann die Folienleiterplatte oder Leiterplatte aber auch an der Linie AA begrenzt werden.

Die an die Anschlussöffnungen 11,11' herangeführten Strompfade 6,6' sind gleich lang und parallel zueinander angeordnet. Sie werden über Zuführungen 6.11,6.11' auf Substratenden oder Stege 4.2,4.2' geführt. Auf diesen Substratenden 4.2,4.2' verlaufen sie auf nur einer Oberfläche zwischen den Anschlussöffnungen 11,11'. Falls die Folienleiterplatte oder Leiterplatte nicht entlang der Linie AA endet, so sind die Substratenden 4,2,4.2' an zwei Seiten fest mit dem Substrat 4 verbunden. Einerseits über die Zuführungen 6.11,6.11' und andererseits über die elektrisch isolierenden Abschlussbereiche 6.4,6.4' und elektrisch isolierenden Verbindungsbereiche 10.6,10.6'. Falls die Folienleiterplatte oder Leiterplatte jedoch entlang der Linie AA endet, so sind die Substratenden 4.2,4.2' nur an einer Seite, nämlich über die Zuführungen 6.11,6.11', fest mit dem Substrat 4 verbunden.

Die Aufgaben der isolierenden Bereiche 10.6,10.6' an den Enden der Strompfade 6,6' werden weiter unten im Detail beschrieben. So erlauben beispielsweise die Abschlussbereiche 6.4,6.4' eine kontrollierte elektrische Kontaktierung oder Bestückung der Leiterplatten oder Folienleiterplatten. Und die Verbindungsbereiche 10.6,10.6' erlauben ein partielles (einseitiges) Lösen der Substratenden 4.2,4.2' vom Substrat 4 mittels Durchtrennen oder Durchschneiden der diesbezüglich bewusst schmal gearbeiteten Verbindungsbereiche 10.6,10.6'. Nach diesem partiellen Lösen besitzen die Substratenden 4.2,4.2' nur noch über die Zuführungen 6.11,6.11' Verbindungen mit der Leiterplatte oder Folienleiterplatte und lassen sich so räumlich ausrichten, beispielsweise in eine bestimmte gewünschte Position verbiegen usw..

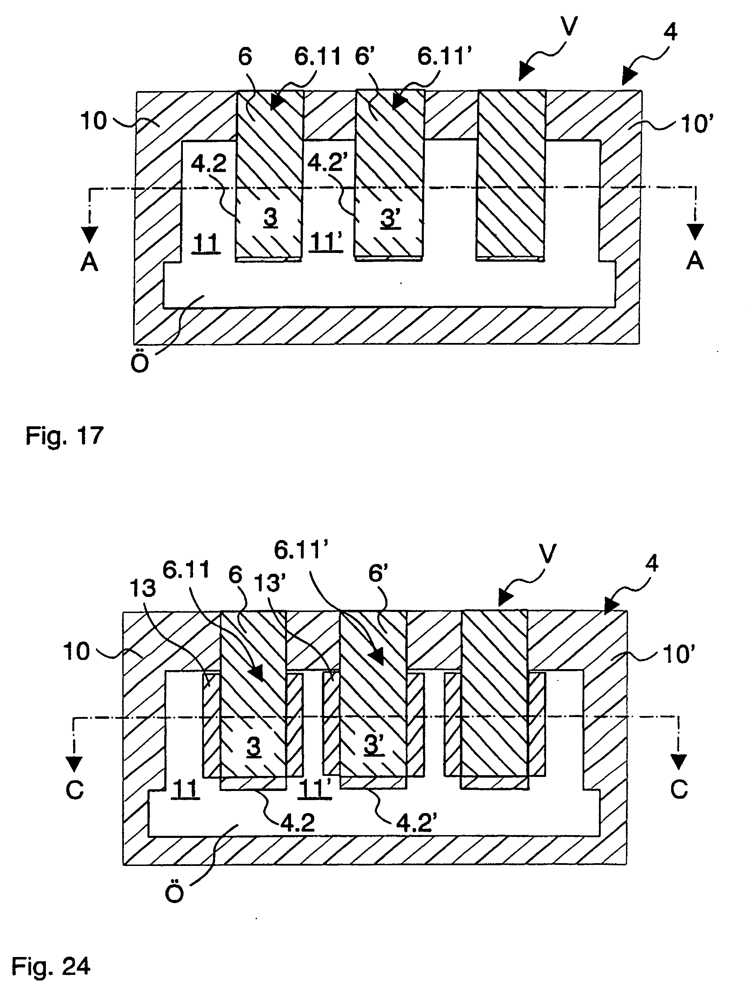

In **Figur 17** wird eine zweite Variante des erfindungsgemässen Verfahrens der photochemischen Strukturierung von Verbindungsmitteln V durch Schnitte eines Teils von Folienleiterplatten und Leiterplatten beschrieben. Diese zweite Variante des Verfahren baut auf den Schritten der ersten Variante des Verfahrens gemäss den Figuren 6 bis 16 auf, indem ein Vorprodukt gemäss Figur 6 bis in ein Herstellungsstadium gemäss den Figuren 15 und 16 weiterbearbeitet und daraufhin einem im folgenden beschriebenen Löseprozess unterworfen wird. In dieser zweiten Variante des erfindungsgemässen Verfahren wird die zweite Ausführungsform von Verbindungsmitteln V in Form kontaktierbarer Anschlussbeinchen gemäss Figur 4 hergestellt.

Figur 17 zeigt demnach eine Draufsicht auf einen Teil einer Folienleiterplatte oder Leiterplatte, dessen Schnitt AA der Ansicht im Querschnitt gemäss Figur 15 entspricht. Zur Herstellung der zweiten Ausführungsform eines Verbindungsmittels V müssen die Öffnungen Ö an äusseren Begrenzungen einer Leiterplatte oder Folienleiterplatte angebracht werden, um so Öffnungen Ö gemäss Figur 4 zu bilden. Dies ist der Fall, wenn man den Teil der Leiterplatte oder Folienleiterplatte gemäss den Figuren 15 und 16 in den Verbindungsbereichen 10.6,10.6' seitlich begrenzt. Dies kann geschehen, indem an den Enden der Strompfade 6,6' der Substratenden 4.2,4.2' entlang der Linie AA gemäss Figur 17 begrenzt werden, also dass hier der Rand der dreilagigen Folie) des Vorprodukts gemäss Figur 6 verläuft, oder es kann sein, dass ein Teil einer Leiterplatte oder Folienleiterplatte in den Verbindungsbereichen 10.6,10.6' gemäss Figur 16 durchgetrennt oder durchgeschnitten wird.

Durch diese Begrenzung entlang der Linie AA oder nach diesem Lösen werden Anschlussbeinchen 3,3' gebildet, die nur über ihre Zuführungen 6.11,6.11' mit dem Substrat 4 verbunden sind. Je nach ihrer Länge und materialspezifischen Flexibilität können die Anschlussbeinchen 3,3' durch entsprechende Instrumente vorgebogen und aus der Ebene des flachen Substrats 4 herausgebogen werden, um dann in dieser vorgeformten Ausrichtung zu verharren. Diese Anschlussbeinchen 3,3' können aber auch recht lang und flexibel gearbeitet sein, sie können beispielsweise so breit oder lang wie die Leiterplatten oder Folienleiterplatten sein, in denen sie strukturiert wurden, sodass sie nach ihrem Lösen auch mit weiter entfernten Verbindungsmittel V derselben Leiterplatte oder Folienleiterplatte oder anderen in diesem Längenbereich angeordneten Schaltungsträgern kontaktierbar sind.

So ist es beispielsweise möglich, ein Array genügend langer Anschlussbeinchen 3,3' gemäss den Figuren 4 und 17 in Anschlussöffnungen 11,11' gemäss Figur 16 zu stecken oder anzubringen Solche Anschlussbeinchen 3,3' werden beispielsweise in die breiten kurzen Elemente 11.2,11.2' der Anschlussöffnungen 11,11' gesteckt und in diesen mechanisch gehalten. Die kleinen rechteckigen Öffnungen Ö zwischen den einzelnen Anschlussbeinchen 3,3' liegen dann auf isolierenden Verbindungsbereichen 10.6,10.6' der Leiterplatte oder Folienleiterplatte auf. Somit stossen die an Strompfade 6,6' der Anschlussbeinchen 3,3' im rechten Winkel an die herangeführten Strompfade 6,6' der Anschlussöffnungen 11,11' an und sind elektrisch kontaktierbar. Je nach Breite der Abschlussbereiche 6.4,6.4' der Strompfade 6,6' und der Öffnungen Ö bilden diese direkt durch das Aufstecken elektrischen Kontakt, oder sie werden in weiteren Arbeitsschritten durch Löten miteinander elektrisch verbunden. Dies kann erwünscht sein, um beispielsweise zu bestückende Schaltungsträger und in diesem Fall die Anschlussbeinchen 3,3' zuerst mechanisch anzubringen und zu positionieren, und um elektrische Kontakte dann mittels Löten zu realisieren.

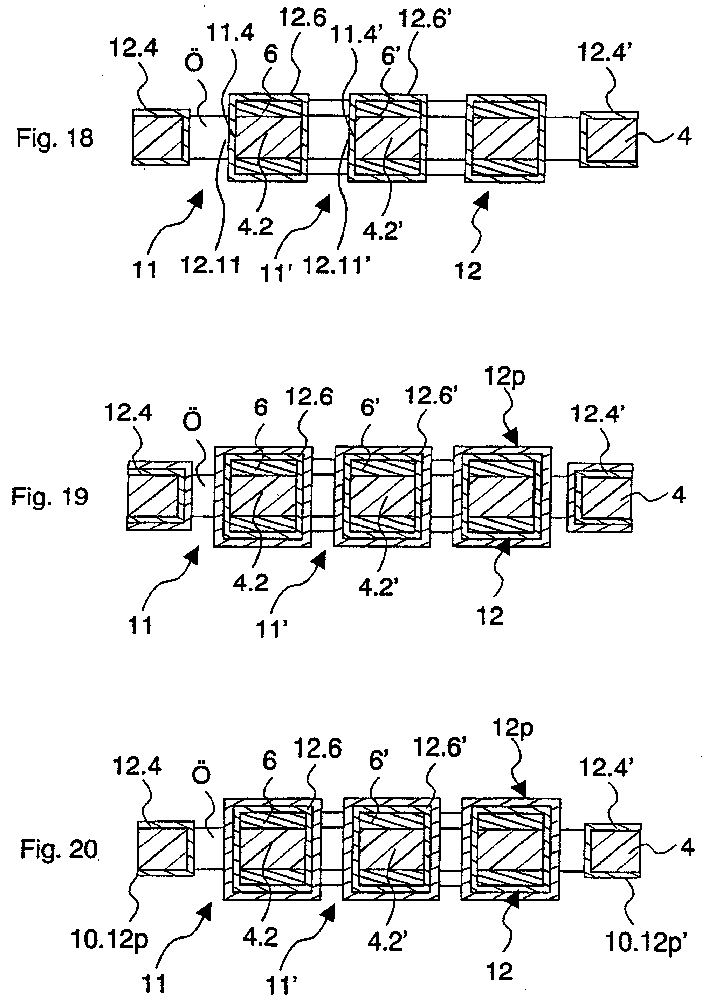

In den **Figuren 18** bis **23** wird eine dritte Variante des erfindungsgemässen Verfahrens der photochemischen Strukturierung von Verbindungsmitteln V wie Anschlussbeinchen 3,3' durch Schnitte eines Teils von Folienleiterplatten und Leiterplatten beschrieben. Diese dritte Variante des Verfahren baut auf den Schritten der ersten Variante des Verfahrens gemäss den Figuren 6 bis 16 auf, indem ein Vorprodukt gemäss Figur 6 bis in ein Herstellungsstadium gemäss den Figuren 15 und 16 weiterbearbeitet und daraufhin einem im folgenden beschriebenen Durchplattierungsprozess unterworfen wird.

In **Figur 18** sieht man das sich im Herstellungsstadium gemäss Figur 15 befindliche Vorprodukt nach Aufplattierung einer elektrisch leitenden Schicht oder Metallschicht 12. Dies geschieht mittels bekannter und bewährter chemischer Methoden, beispielsweise durch galvanisches Abscheiden von Kupfer. Die Metallschicht 12 umschliesst das Vorfabrikat vollständig, d.h sie bedeckt die Strompfade 6,6', die Innenflächen 11.4,11.4' der Anschlussöffnungen 11,11' und die Isolatorschicht 4 mit einer elektrisch leitenden Schicht Kupfer. Auf den Innenflächen der Anschlussöffnungen 11,11' wird dies als Metallschicht 12.11,12.11' bezeichnet. Auf den Strompfaden 6,6' wird sie Metallschicht 12.6,12.6' genannt. Auf der Isolatorschicht 4 wird sie Metallschicht 12.4,12.4' genannt. Diese Metallschichten 12.11,12.11' sowie 12.6,12.6' grenzen nahtlos aneinander. Die aufplattierte leitende Schicht 12 erzeugt im Zustand gemäss Figur 18 natürlich Kurzschlüsse zwischen den Strompfaden 6,6' und wird im folgenden photochemisch gemäss eines Aufplattierungsentwurfs strukturieren.

In **Figur 19** sieht man das aufplattierte Vorprodukt gemäss Figur 18 nach dem Auftragen einer Photoresistschicht 12p auf die aufplattierte leitende Schicht 12. Hierfür wird vorteilhafterweise flüssiger Photoresist 12p verwendet. Auch die aufplattierten Innenflächen der Anschlussöffnungen 11,11' werden mit Photoresist 12p bedeckt. Das Photoresist 12p wird in photochemischen Verfahren belichtet und überträgt so den Aufplattierungsentwurf über Photomasken. Der Aufplattierungsentwurf beinhaltet Position und Struktur der herzustellenden Strompfade und Isolatorbereiche in der Metallschicht 12. Der Aufplattierungsentwurf ist eine Ergänzung, eine Erweiterung des Schaltungsentwurfs und des Verbindungsmittelentwurfs.

In **Figur 20** sieht man die gemäss dem Aufplattierungsentwurf photochemisch durchgeführte Strukturierung der Schicht Photoresist 12p. In der strukturierten Schicht Photoresist 12p werden Isolatorstrukturen 10.12p,10.12p' gebildet, welche bis auf die Metallschicht 12 herabreichen. Die mit Photoresist bedeckten Bereiche der Metallschicht 12 werden in der folgenden photochemischen Bearbeitung durch dieses Photoresist vor nasschemischem Ätzen geschützt.

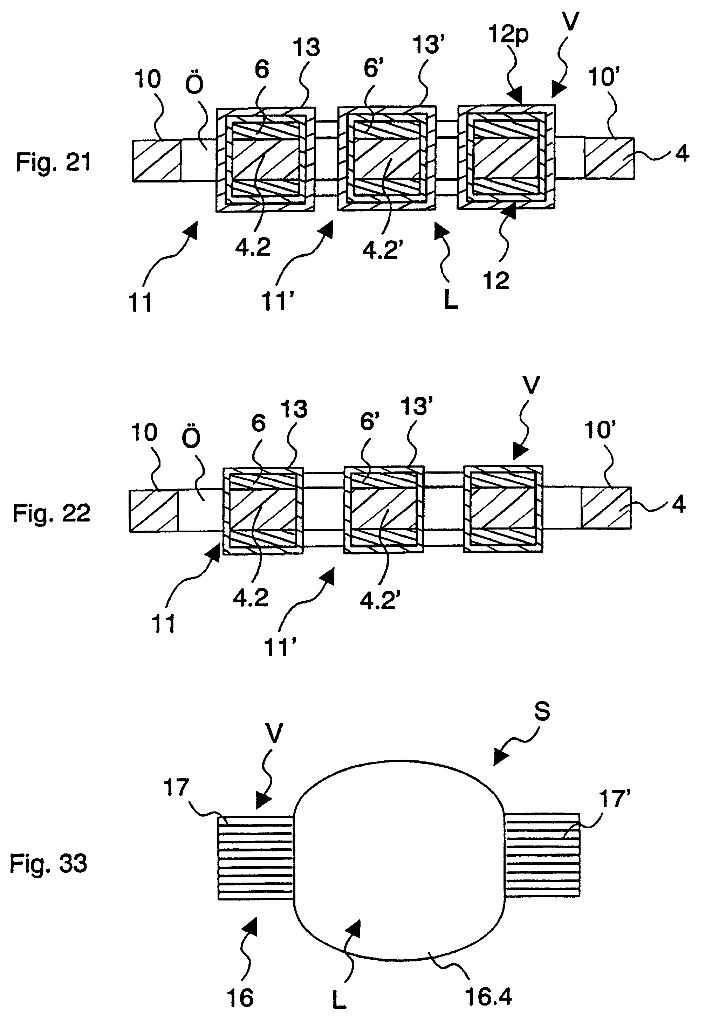

In **Figur 21** sieht man die mit einer photochemisch strukturierten Schicht Photoresist 12p bedeckte Metallschicht 12 nach erfolgtem nasschemischen Ätzen des von Photoresist unbedeckten Metalls der Metallschicht 12. Dieses Ätzen erfolgt gemäss dem Aufplattierungsentwurf nur im Bereich der mit Photoresist unbedeckten Isolatorstrukturen 10.12p,10.12p' und führt zur gezielten Bildung elektrisch nichtleitender Bereiche, welche Isolatorbereiche 10,10' genannt werden und führt zur Bildung elektrisch leitender Bereiche, welche aufplattierte erweitete Strompfade 13,13' genannt werden. Die Isolatorbereiche 10,10' und durch die Aufplattierung erweiterte Strompfade 13,13' sind Teile der so realisierten Schaltung oder Leiterbildes L und isolieren die erweiterten Strompfade 13,13' gegeneinander. In der vorliegenden Ausführungsform fallen die aus der später aufplattierten Metallschicht 12 hergestellten erweiterten Strompfade 13,13' und die aus den ursprünglichen Metallschichten 7,8 hergestellten Strompfade 6,6' zusammen. Dies muss aber nicht so sein. Die aufplattierten erweiterten Strompfade 13,13' können ebenso wie die ursprünglichen Strompfade 6,6' gemäss eines eigenständigen Schaltungsentwurfs verlaufen. Beispielsweise können sie als gegeneinander elektrisch isolierte Innenflächen-Strompfade in Öffnungen und Durchgangslöchern wie den Anschlussöffnungen 11,11' verlaufen. Solche photochemisch zu strukturierende Öffnungen sollen minimale Durchmesser und maximale Tiefen aufweisen und günstige Längenverhältnisse der minimalen Durchmesser zu maximalen Tiefen von ungefähr 1 zu 1 besitzen. Eine entsprechende Erfindung ist von der gleichen Anmelderin in der Schweizerischen Patentanmeldung Nr. 013081936 offenbart worden.

Die durch diese Aufplattierung durchgeführte Verstärkung der Strompfade 6,6' in erweiterte Strompfade 13,13' wird also nicht aus montagetechnischen Gründen vorgenommen, denn diese Verstärkung findet ja gemäss des Aufplattierungsentwurfs in allen Bereichen der Leiterplatte oder Folienleiterplatte statt, also auch in solchen, die ausserhalb des Bereichs der Verbindungsmittel V liegen. Die Aufplattierung dient vielmehr der optimalen Strukturierng des Leiterbilds L, sie ermöglicht eine grössere Gestaltungsfreiheit der Verbindungsmittel V, sie erlaubt in diesem Falle eine hier nicht gezeigte, aber mögliche Strukturierung aller Oberflächen von Substratenden 4.2,4.2' in Strompfade.

In **Figur 22** sieht man das sich im Herstellungsstadium gemäss Figur 21 befindliche Vorprodukt nach Entfernen der restlichen Schicht Photoresist 12p. Dies geschieht mittels bekannter und bewährter chemischer Prozesse. Die dritte Variante des erfindungsgemässen Verfahrens zur Herstellung von Leiterplatten, Folienleiterplatten und Halbzeugen für Leiterplatten und Folienleiterplatten aus dem Vorprodukt gemäss Figur 6 ist somit abgeschlossen.

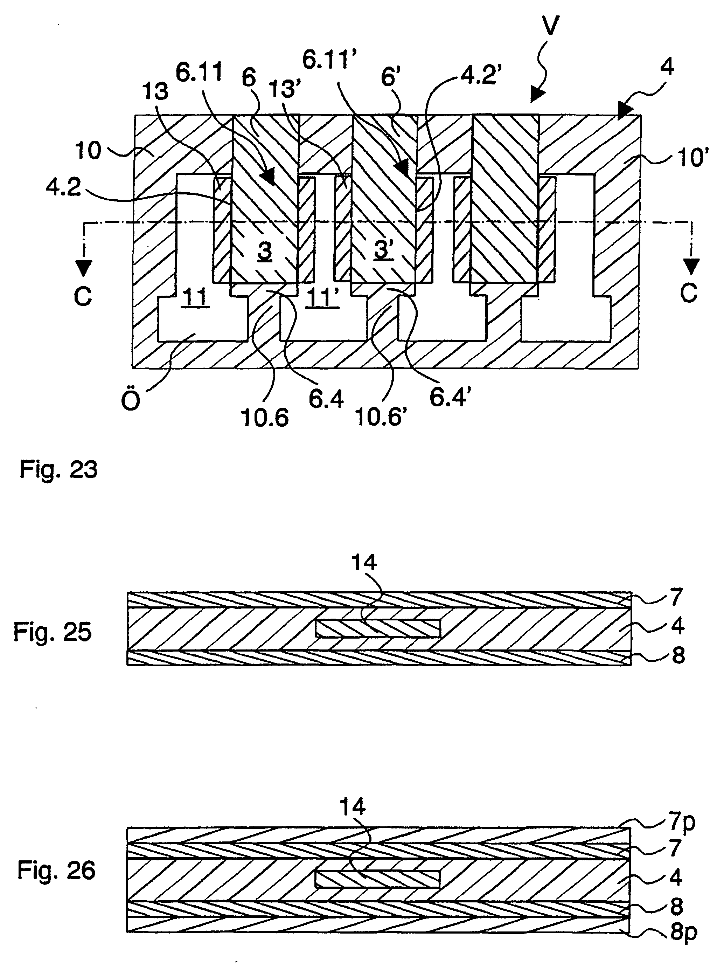

In **Figur 23** sieht man eine Draufsicht auf einen Teil einer Folienleiterplatte oder Leiterplatte, dessen Schnitt CC der Ansicht im Querschnitt gemäss Figur 22 entspricht. Die Öffnungen Ö und die erweiterten Strompfade 13,13' werden durch das Substrat 4 gegeneinander getrennt, mechanisch getragen und elektrisch gegeneinander isoliert. Auf der Oberfläche werden die Strompfade 13,13' durch isolierende Bereiche 10,10' gegeneinander isoliert. In Analogie zur vierten Ausführungsform eines Verbindungsmittels V gemäss den Figuren 15 und 16 sind an den Enden der herangeführten Strompfade 13,13' Abschlussbereiche 6.4,6.4' und Verbindungsbereiche 10.6,10.6' angebracht. Im Unterschied hierzu, sind die an die Öffnungen Ö herangeführten Strompfade 13,13' nun nicht mehr nur auf einer der Oberflächen der sie mechanisch tragenden Substratenden 4.2,4.2' gearbeitet, sondern die Substratenden 4.2,4.2' sind jetzt vollumfänglich, mit einer geschlossen aufplattierten elektrisch leitenden Schicht gearbeitet. Diese mit vollumfänglich aufplattierten herangeführten Strompfaden 13,13' versehenen Anschlussöffnungen 11,11' stellen eine fünfte Ausführungsform von im erfindungsgemässen Verfahren hergestellten Verbindungsmitteln V dar. Erfindungsgemäss kann die Folienleiterplatte oder Leiterplatte aber auch an der Linie CC begrenzt werden, sodass Verbindungsmitteln V in Form vollumfänglich aufplattierter kontaktierbarer Anschlussbeinchen hergestellt werden.

In **Figur 24** wird eine vierte Variante des erfindungsgemässen Verfahrens der photochemischen Strukturierung von Verbindungsmitteln V durch Schnitte eines Teils von Folienleiterplatten und Leiterplatten beschrieben. Diese vierte Variante des Verfahren baut auf Schritten der ersten und dritten Variante des Verfahrens gemäss den Figuren 6 bis 16 bzw. 18 bis 23 auf, indem ein Vorprodukt gemäss Figur 6 bis in ein Herstellungsstadium gemäss den Figuren 22 und 23 weiterbearbeitet und daraufhin einem im folgenden beschriebenen Löseprozess unterworfen wird. Es wird eine sechste Ausführungsform von Verbindungsmitteln V in Form vollumfänglich aufplattierter kontaktierbarer Anschlussbeinchen 3,3' hergestellt. Figur 24 zeigt demnach eine Draufsicht auf einen Teil einer Folienleiterplatte oder Leiterplatte, dessen Schnitt CC der Ansicht im Querschnitt gemäss Figur 22 entspricht. In Analogie zur zweiten Variante des Verfahrens gemäss Figur 17 werden die Anschlussöffnungen 11,11' in den Verbindungsbereichen 10.6,10.6' gemäss Figur 23 durchgetrennt oder durchgeschnitten, sodass vollumfänglich aufplattierte kontaktierbare Anschlussbeinchen 3,3' entstehen, die nur noch partiell, nur noch über die Zuführungen 6.11,6.11' fest mit dem Substrat 4 verbunden sind. Die geschlossen gearbeiteten elektrisch leitenden Schichten 13,13' weisen eine gegenüber den zweiseitig (oben und unten) gearbeiteten leitenden Schichten 6,6' gemäss den Figuren 15 und 16 den Vorteil der höheren mechanischen Steifigkeit auf. Diese steiferen Strompfade 13,13' lassen sich besser räumlich ausrichten und behalten eine bestimmte, gewählte räumliche Ausrichtung, beispielsweise ein Verbiegen in einem gewissen Winkel, bei.

In den **Figuren 25** bis **32** wird eine fünfte Variante des erfindungsgemässen Verfahrens der photochemischen Strukturierung von Verbindungsmitteln V wie ein abgeschirmtes Kabel 15 durch Schnitte eines Teils von Folienleiterplatten und Leiterplatten beschrieben. Ausgehend von einem dreilagigen Folie als Vorprodukt mit zwei äusseren Lagen elektrisch leitender Schichten (Metallschichten), einer Isolatorschicht oder Substrat und einem vollständig in dieser Isolatorschicht eingebetteten Strompfad, wird in einem photochemischen Verfahren die Strukturierung (Layout) der Schaltung und die der Isolieröffnungen mit aufplattierten Abschirmungen vorgenommen. Diese fünfte Variante des Verfahren erfolgt in Analogie zur ersten und dritten Variante des Verfahrens.

In **Figur 25** sieht man einen Teil einer dünnen dreilagigen Folie als Vorprodukt, bei der zwei äussere elektrisch leitende Schichten oder Metallschichten 7,8 voneinander durch eine Isolatorschicht oder ein Substrat 4 getrennt sind und bei der ein Strompfad als Kabelader 14 vollständig eingebettete im Substrat 4 verläuft. Dieser Strompfad oder diese Kabelader 14 ist vorteilhafterweise in seiner ganzen Länge in gleichmässiger Dicke gearbeitet.

In **Figur 26** sieht man das Vorprodukt nach dem Auftragen zweier Photoresistschichten 7p,8p auf die leitenden Schichten 7,8, sodass diese vollständig mit Photoresisit bedeckt sind. Es kann festes oder flüssiges Photoresist verwendet werden. Die Schichten Photoresist 7p,8p können in bekannten photochemischen Verfahren belichtet werden und können so einen Schaltungsentwurf und einen Verbindungsmittelentwurf über Photomasken übertragen. Der Schaltungsentwurf beinhaltet Position und Struktur der herzustellenden Leiterbahnen oder Strompfade und Isolierbereiche in den Metallschichten 7,8. Der Verbindungsmittelentwurf beinhaltet Position und Struktur der herzustellenden Verbindungsmittel V. Diese beide Entwürfe, der Schaltungsentwurf und Verbindungsmittelentwurf sind aufeinander abgestimmt und ergänzen sich.

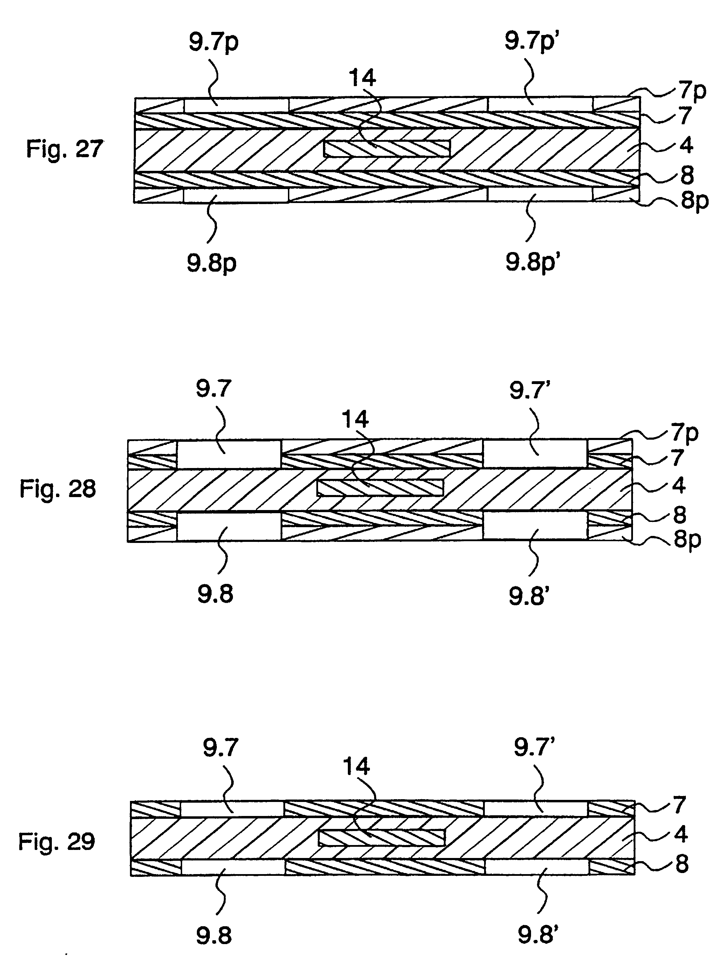

In **Figur 27** sieht man die gemäss den Verbindungsmittel- und den Schaltungsentwürfen photochemisch durchgeführte Strukturierung der Schichten Photoresist 7p,8p. In den strukturierten Schichten Photoresist 7p und 8p werden Verbindungsmittelstrukturen 9.7p,9.7p' und 9.8p,9.8p' gebildet, welche bis auf die metallischen Schichten 7 und 8 herabreichen.

In **Figur 28** sieht man die mit photochemisch strukturierten Schichten Photoresist 7p,8p bedeckten Metallschichten 7,8 nach erfolgtem nasschemischen Ätzen des von Photoresist unbedeckten Metalls der Metallschichten 7,8. Dieses Ätzen erfolgt gemäss dem Verbindungsmittelentwurf nur im Bereich der Verbindungsmittelstrukturen 9.7p,9.7p' und 9.8p,9.8p' und führt zur gezielten Bildung von Verbindungsmittelmündungen 9.7,9.7'und 9.8,9.8' welche bis auf die Isolatorschicht 4 hinabreichen.

In **Figur 29** sieht man das sich im Herstellungsstadium gemäss Figur 28 befindliche Vorprodukt nach Entfernen der Schichten Photoresist 7p und 8p. Dies geschieht mittels bekannter und bewährter chemischer Prozesse.

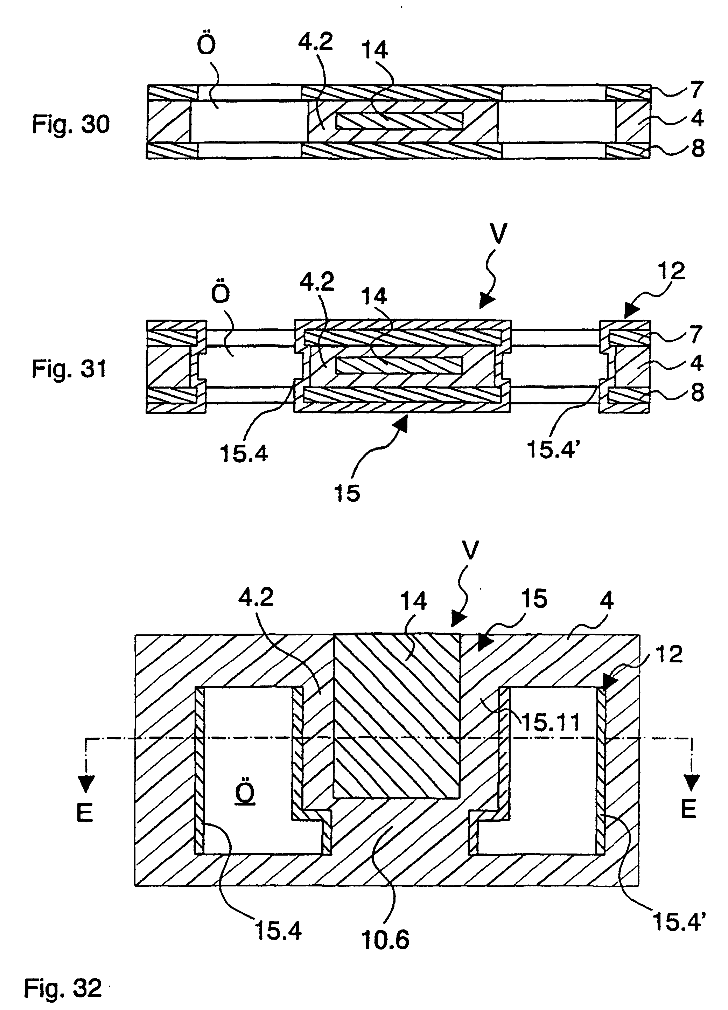

In **Figur 30** sieht man das gemäss Figur 29 von Photoresist gesäuberte Vorprodukt nach dem Plasma-Ätzen von Verbindenden zwischen den Verbindungsmittelmündungen 9.7,9.7'und 9.8,9.8' durch die Isolatorsschicht 4 hindurch. Durch diese Verbindenden werden die Verbindungsmittelmündungen 9.7,9.7' und 9.8,9.8' der beiden Metallschichten 7,8 miteinander verbunden und bilden so Öffnungen Ö. Der Strompfad 14 verläuft somit im Innern eines diesen vollständig und mit gleichmässiger Dicke umschliessenden Substratendes 4.2.

In **Figur 31** sieht man das sich im Herstellungsstadium gemäss Figur 30 befindliche Vorprodukt nach Aufplattierung einer elektrisch leitenden Schicht oder Metallschicht 12. Dies geschieht mittels bekannter und bewährter chemischer Methoden, beispielsweise durch galvanisches Abscheiden von Kupfer. Die Metallschicht 12 umschliesst das Vorfabrikat vollständig, d.h sie bedeckt die strukturierten Metallschichten 7,8, die Innenflächen 15.4,15.4' der Öffnungen Ö und die Isolatorschicht 4 mit einer elektrisch leitenden Schicht Kupfer. Die vollständig im Substrat 4 eingebettet verlaufende Kabelader 14 wird durch die diese beiden vollständig umschliessende Aufplattierung elektromagnetisch abgeschirmt. Dies ist eine siebte Ausführungsform eines im erfindungsgemässen Verfahrens hergestellten Verbindungsmittels V in Form eines abgeschirmten Kabels 15.

Solche abgeschirmten Kabel 15 mit kontrolliert und gleichmässig hergestellten Dicken und Längen der Kabelader 14, der Isolierbereiche und der Abschirmung, die ein- oder zweiseitig (d.h. an ihren Enden) fest mit dem Substrat 4 verbunden sind und die partiell lösbar sind (d.h. die an einem ihrer Enden lösbar sind, siehe Figur 32) und die in Funktion ihrer Steifigkeit und Flexibilität räumlich orientierbar sind, eignen sich für Anwendungen der Übertragung hochfrequenter Signale. Aus montagetechnischen Gründen muss dieses Verbindungsmittel V nicht verstärkt oder in seiner räumlischen Ausdehnung modifiziert werden. Solche Vorprodukte im Herstellungsstadium gemäss Figur 31 eignen sich nicht nur als vollabgeschirmte Kabel, sie können natürlich auch mit Oberflächen-Strompfaden, d.h. mit Strompfaden 6,6' in den äusseren leitenden Schichten, wie es in den Verfahrenschritten gemäss den Figuren 18 bis 23 geschieht, versehen werden. Für diesen Zweck muss man das Vorprodukt analogen Verfahrensschritten unterwerfen.

In **Figur 32** sieht man einen Schnitt auf einen Teil einer Folienleiterplatte oder Leiterplatte, dessen Schnitt EE der Ansicht im Querschnitt gemäss Figur 31 entspricht. Die aufplattierte Metallschicht 12 und der innenliegende Strompfad 14 werden durch das Substratende 4.2 gegeneinander getrennt, mechanisch getragen und elektrisch gegeneinander isoliert. In Analogie zur vierten Ausführungsform eines Verbindungsmittels V gemäss den Figuren 15 und 16 oder zur fünften Ausführungsform eines Verbindungsmittels V gemäss den Figuren 22,23 und 24 sind am Ende des herangeführten Strompfads 14 Verbindungsbereiche 10.6, angebracht an denen das abgeschirmte Kabel 15 einseitig durchtrennt oder durchschnitten werden kann und sodass das abgeschirmte Kabel 15 nur noch partiell, d.h. nur noch über die Zuführung 15.11 fest mit dem Substrat 4 verbunden ist. Erfindungsgemäss kann die Leiterplatte oder Folienleiterplatte vorteilhafterweise entlang der Linie EE begrenzt werden, sodass Anschlussbeinchen gebildet werden.

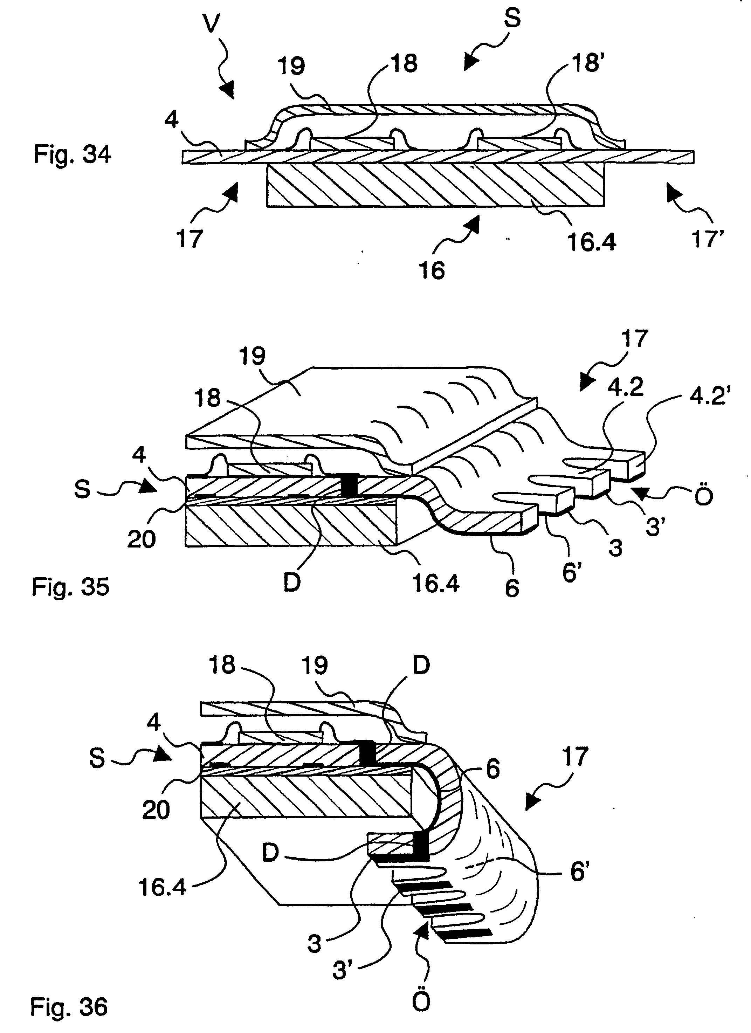

Die **Figuren 33** und **34** zeigen in Draufsicht und Seitensicht eine weitere Ausführungsform einer Leiterplatte oder Folienleiterplatte mit erfindungsgemässen Verbindungsmitteln V und zwar als Schaltungsträger S, beispielsweise als Multi-Chip-Module (MCM). In dieser Ausführungsform einer Leiterplatte oder Folienleiterplatte wird ein mehrlagig gearbeiteter Schaltungsträger S im erfindungsgemässen Verfahren nach Varianten oder in Kombinationen von Varianten gemäss den Figuren 6-32 hergestellt, der steife Bereiche 16 und flexible Bereiche 17 aufweist. Die steifen Bereiche 16 stellen Schaltungsbereiche mit anwendungsspezifischen und nicht weiter detailliert dargestellten Leiterbildern L dar, wo Strompfade in Lagen auf Substraten verlaufen. Die flexiblen Bereiche 17,17' bilden Verbindungsmittel V in Form parallel zueinander gegen den Rand des Schaltungsträgers S verlaufender Strompfade, die dort Anschlussbeinchen darstellen. Diese ähneln somit der Ausführungsform gemäss Figur 4. Die steifen Bereiche verfügen über steife Substrate 16.4, die flexiblen Bereiche 17,17' verfügen über ein oder mehrere flexibel gearbeitete Substrate 4. Die Verbindungsmittel V sind als Anschlussbeinchen ausgeformt, sodass Strompfade auf Substratenden herangeführt werden. Der Schaltungsträger S weist ferner drahtgebondete Chips 18,18' auf, die durch einen metallischen Deckel 19 geschützt sind.

**Figur 35** zeigt als räumliche Darstellung eines Schnittes einen Teil eines Randbereichs des MCM im vergrösserten Massstab. Es ist daraus ersichtlich, dass der Schaltungsträger S ein flexibles Substrat 4 aufweist, beispielsweise eine Isolatorschicht in Form einer dünnen Polyimidfolie, die beidseitig Leiterebenen oder Strompfade 6,6' trägt, beispielsweise strukturierte Metallschichten und die mit Hilfe einer Kleberfolie 20 auf dem steifen Substrat 16 aufgebracht ist. Die parallel zueinander verlaufenden Strompfade 6,6' des flexiblen Bereichs 17 verlaufen auf der dem steifen Substrat 16 zugewandten Seite des Schaltungsträgers S. Ihre dem Rand des Schaltungsträgers S zugewandten Enden bilden Anschlussbeinchen 3,3', welche auf Substratenden 4.2,4.2' liegen, die durch schlitzförmige Öffnungen Ö im flexiblen Substrat 4 voneinander getrennt sind. Diese Anschlussbeinchen 3,3' werden mit entsprechenden Lötpads beispielsweise auf einer Leiterplatte oder Folienleiterplatte verlötet, wobei die schlitzförmigen Öffnungen Ö das Zusammenfliessen des Lotes benachbarter Lötstellen unterbinden.

**Figur 36** zeigt eine weitere Ausführungsform, bei der die Lötstellen nicht wie in der Figur 35 neben dem steifen Substrat 16, sondern darunter liegen. Die parallelen zueinander herangeführten Strompfade 6,6' des Randes des flexiblen Bereichs 17 verlaufen wiederum auf der dem steifen Substrat 16.4 zugewandten Seite des Schaltungsträgers S, bis auf die effektiven Lötstellen, für die sie via entsprechender Durchplattierungen D auf die andere Seite des Schaltungsträgers S geführt werden. Auch hier wird ein Zusammenfliessen des Lots durch schlitzförmige Öffnungen Ö im flexiblen Substrat 4 verhindert. Die nach aussen weisenden Flächen des flexiblen Substrats 4 stellen somit nach einer Kontaktierung einen Schutz vor schädlichen äusseren Einflüssen der herangeführten Strompfade 6,6' und der Anschlussbeinchen 3,3' dar.

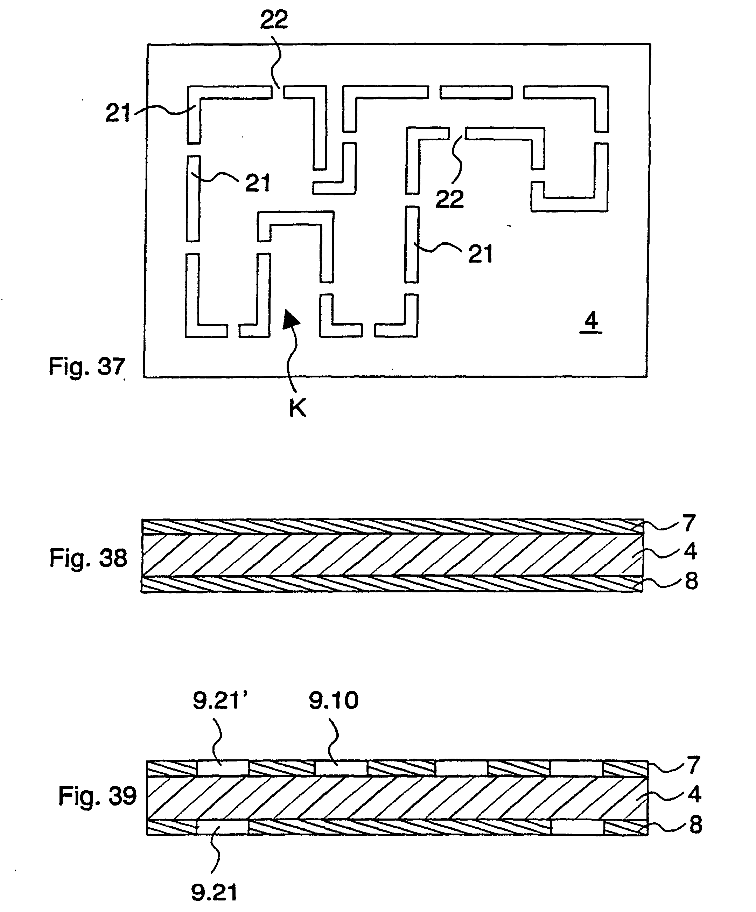

**Figur 37** zeigt schematisch als Draufsicht eine weitere beispielhafte Ausführungsform von Leiterplatten, Folienleiterplatten oder Halbzeug zur Herstellung derselben mit komplizierten Konturen K im Substrat. Es handelt sich dabei um ein rechteckiges Substrat oder Nutzen 4, auf dem die ganze Materialdicke durchdringende Konturöffnungen 21 angebracht sind. Die Konturöffnungen 21 sind auf der vorgegebenen Konturlinie der herzustellenden Schaltungen oder Leiterbilder angeordnet und durch Verbindungsstege 22 unterbrochen. Das Leiterbild (nicht dargestellt) befindet sich innerhalb der geschlossenen Konturlinie und ist in einem fertigen Zustand. Die Position der Verbindungsstege 22 wird dadurch bestimmt, dass sie die potentielle Schaltung derart im Substrat 4 festhalten müssen, dass dieses problemlos manipuliert werden kann während Verarbeitungsschritten, die auf den oder die Schritte, in denen die Konturöffnungen 21 hergestellt werden, folgen. Ferner sind die Verbindungsstege 22 vorteilhafterweise an Positionen angeordnet, an denen auf eine höchste Konturgenauigkeit verzichtet werden kann. Die Verbindungsstege 22 können einfach, beispielsweise mit einer Schere, durchgetrennt werden und es kann so auf ein Nachbearbeiten der Konturpositionen der Verbindungsstellen verzichtet werden. Die Kontur K der Schaltung kann bereichsweise mit der Kontur des Substrats oder Nutzens 4 zusammenfallen.

Da die Konturöffnungen photochemisch definiert und durch Ätzen hergestellt werden, entfällt die Herstellung von Werkzeugen für den Endzuschnitt und erhöht sich die Präzision dieses Endzuschnittes. Wegen der erhöhten Präzision und weil alle Konturöffnungen simultan und ohne mechanische Krafteinwirkung erstellt werden, können problemlos Konturen K erstellt werden mit Abständen von ca. 0,1 mm, was durch Fräsen unmöglich, durch Feinstanzen kaum zu erreichen ist.

Die Konturöffnungen können quasi beliebig schmal (bis unter 0,01 mm) sein, sodass Leiterbilder in den Leiterplatten, den Folienleiterplatten oder dem Halbzeug zur Herstellung derselben sehr eng nebeneinander angeordnet sein können, was gegenüber den Verfahren gemäss dem Stande der Technik (Fräsen, Stanzen) zu Materialeinsparungen führt.

Die **Figuren 38** bis **40** zeigen drei Stadien einer beispielhaften Verfahrensvariante zur Herstellung solcher Konturen K gemäss Figur 37 für eine Schaltung mit zwei Leiterebenen. Die Leiterplatten, Folienleiterplatten oder das Halbzeug zur Herstellung derselben wird aus einer Folie hergestellt, wie sie in Figur 38 dargestellt ist. Diese Folie weist eine mittlere, elektrisch isolierende Schicht 4 vorzugsweise aus einem Polymer, beispielsweise Polyimid oder Epoxidharz, auf und beidseitige elektrisch leitende Schichten 7,8, beispielsweise aus Kupfer.

Wie in der **Figur 39** dargestellt, werden die beiden leitenden Schichten 7 und 8 mit an sich bekannten Verfahren photochemisch strukturiert und zwar derart, dass an den Stellen 9.21, 9.21' der vorgesehenen Konturöffnungen beidseitig die Isolationsschicht 4 freigelegt wird, während beispielsweise für die schaltungsrelevante Strukturierung an Stellen 9.10 die Isolationsschicht nur einseitig freigelegt wird.

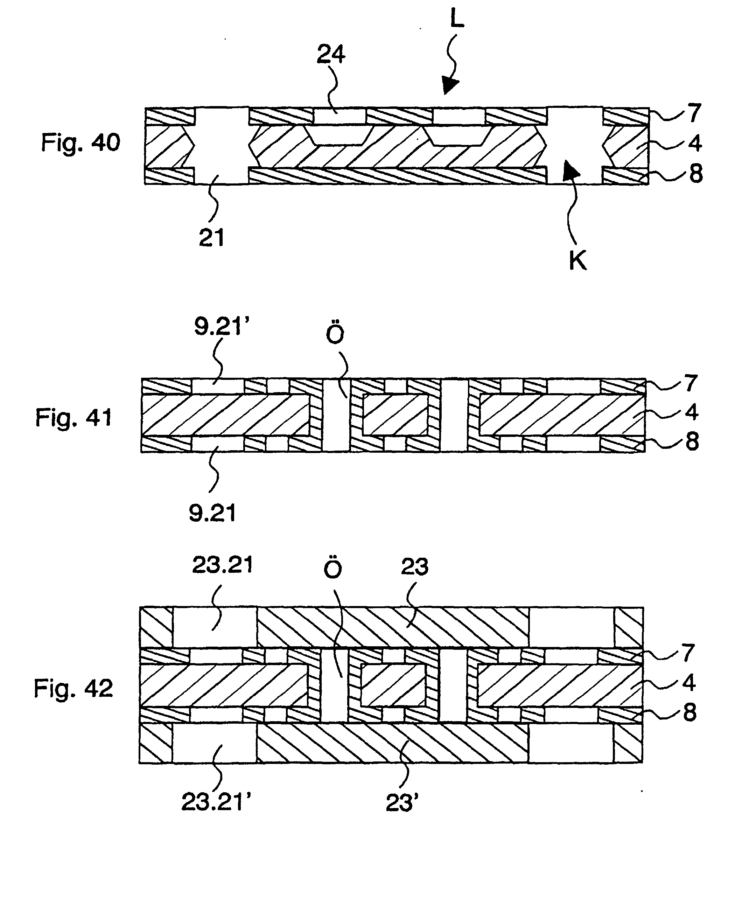

Wird nun die in der Figur 39 dargestellte Folie einem Plasmaätzschritt unterzogen, entsteht die strukturierte Folie gemäss **Figur 40,** wenn die Ätzparameter derart auf Material und Dicke der Isolationsschicht 4 abgestimmt sind, dass etwa die Hälfte ihrer Dicke abgetragen wird. Die strukturierte Folie weist durchgehende Konturöffnungen 21 auf.

Die **Figuren 41 bis 44** zeigen vier Stadien einer weiteren beispielhaften Verfahrensvariante zur Herstellung komplizierter Konturen einer Schaltung gemäss Figur 37 in Leiterplatten, Folienleiterplatten oder Halbzeug zur Herstellung derselben.

Das Ausgangsprodukt ist eine Folie mit isolierender Mittelschicht 4 und leitenden Aussenschichten 7,8 wie bereits in der Figur 38 gezeigt. Diese Folie wird zu einer anwendungsspezifischen Schaltung, wie sie in **Figur 41** gezeigt ist, strukturiert, indem beispielsweise zuerst die leitenden Schichten 7,8 durch photochemische Prozesse derart strukturiert werden, dass sie die Mittelschicht 4 an Stellen für Z-Verbindungen beidseitig freigeben, indem die Öffnungen Ö für die Z-Verbindungen durch Trockenätzen geöffnet und galvanisch durchplattiert werden und indem dann wiederum durch photochemische Prozess die leitenden Aussenschichten 7,8 zu Leitermustern strukturiert werden. Für Konturöffnungen werden nun, wie in der Figur 41 gezeigt, mit den letztgenannten photochemischen Prozessen zur Erstellung der Leiterstrukturen auch an einander gegenüberliegenden Stellen 9.21, 9.21' Bereiche der Mittelschicht 4 freigelegt.

**Figur 42** zeigt, wie in einem weiteren Verfahrensschritt auf die bis auf den Endschnitt fertige Schaltung beidseitig Schablonen 23 und 23' aus beispielsweise Stahlblech aufgepresst werden, wobei die Schablonen wiederum an den Stellen der vorgesehenen Konturöffnungen Öffnungen 23.21 und 23.21' aufweisen.

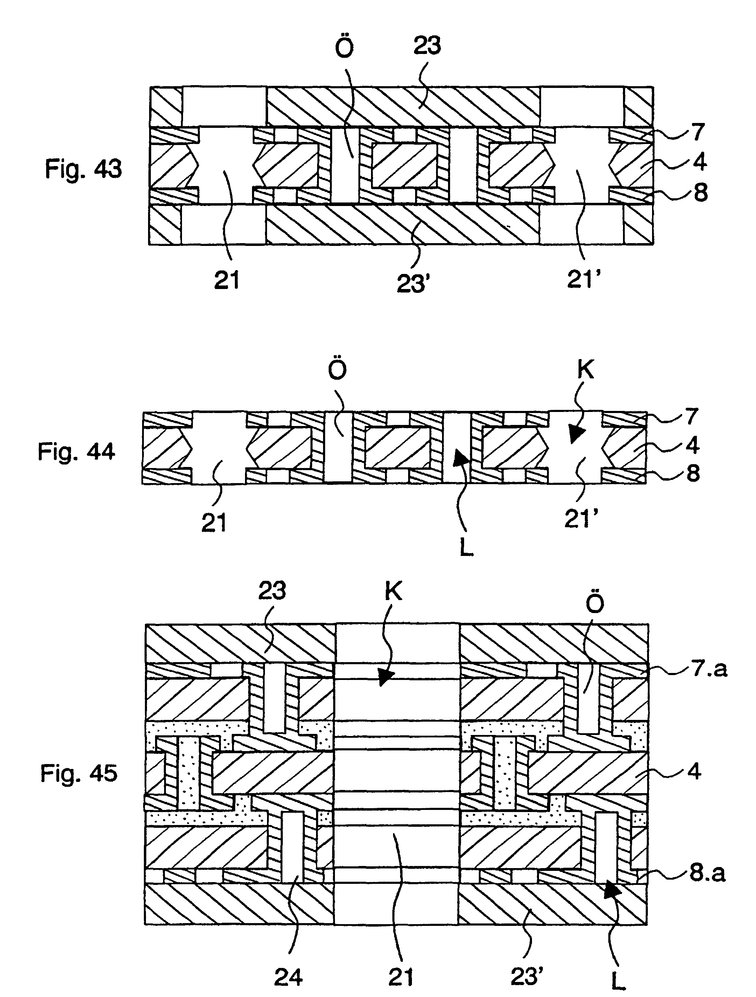

**Figur 43** zeigt das Produkt mit den Schablonen 23,23' nach einem Trockenätzschritt, in dem die beidseitig weder von den Leiterschichten 7,8 noch von den Schablonen 23,23' abgedeckten Stellen der Konturöffnungen 21,21' durchgeätzt werden.

**Figur 44** zeigt eine fertige Leiterplatte, Folienleiterplatte oder Halbzeug zur Herstellung derselben mit den Konturöffnungen 21,21'.

Eine Variante zu dem in den Figuren 41 bis 44 dargestellten Verfahren besteht darin, dass die Konturöffnungen zusammen mit den Öffnungen für die Durchplattierungen erstellt werden. Es ist dann allerdings nicht zu verhindern, dass im folgenden Durchplattierungsschritt auch die Konturöffnungen "durchplattiert" werden, wobei die Kupferschicht im Bereiche der Konturöffnungen allerdings im darauffolgenden photochemischen Strukturierungsschritt wieder entfernt werden kann.

**Figur 45** zeigt nun noch analog zu Figur 43 eine Phase im Herstellungsverfahren für ein Halbzeug, das drei Folienlagen aufweist. Die Figur stellt das fertige Halbzeug dar, auf das noch die Schablonen 23 und 23' aufgepresst sind, mit deren Hilfe die Konturöffnungen 21 erstellt worden sind. Das dargestellte Halbzeug wird vorgängig hergestellt durch Strukturierung einer mittleren Folienlage mit dem Verfahren, wie es bereits im Zusammenhang mit der Figur 41 skizziert worden ist. Dann werden beidseitig je eine weitere Folienlage mit je einer aussenliegenden leitenden Schicht auflaminiert und diese wird ebenfalls photochemisch, durch Nassätzen, durch Trockenätzen und galvanisch strukturiert zu je einer äusseren Leiterebene 7.a und 8.a mit Sacklöchern 24 auf die inneren Leiterebenen. Sowohl bei der Strukturierung der inneren als auch bei der Strukturierung der äusseren Leiterebenen werden die leitenden Schichten im Bereiche der zu erstellenden Konturöffnungen 21 entfernt, derart dass das Halbzeug in den Bereichen der Konturöffnungen nur isolierende Schichten aufweist.

Auf ein derartig vorbereitetes Halbzeug werden nun, wie in der Figur 45 dargestellt, Schablonen 23 und 23' aufgepresst, die einander gegenüberliegende, den zu erstellenden Konturöffnungen entsprechende Öffnungen 23.21 und 23.21' besitzen. Dann wird das Halbzeug mit den Schablonen einem Trockenätzschritt unterzogen, wobei die Ätzparameter derart eingestellt werden, dass das Halbzeug von beiden Seiten mindestens halb durchgeätzt wird, wodurch die durchgehenden Konturöffnungen 21 entstehen.

Selbstverständlich können die Konturöffnungen an einem Halbzeug, wie es in der Figur 45 dargestellt ist, auch in jeder Folienlage separat zusammen mit den entsprechenden Z-Verbindungen erstellt werden. Selbstverständlich kann das Halbzeug auch mehr als drei Folienlagen aufweisen.

## Patentansprüche

1. Verfahren zur Herstellung von Leiterplatten, Folienleiterplatten, Halbzeugen für Leiterplatten und Halbzeugen für Folienleiterplatten, mit strukturierten elektrisch leitenden Schichten und mit Konturöffnungen (21) für eine Strukturierung der äusseren Form, mit den Schritten:
a) zur Verfügung stellen eines platten- oder folienförmigen eine oder mehrere elektrisch isolierende Schichten aufweisenden Substrates (4), welches beidseitig mit einer leitenden Schicht (7, 8) versehen ist,
b) Strukturieren der leitenden Schichten (7, 8) durch partielles Abtragen von leitendem Material, wobei gleichzeitig schaltungsrelevante Strukturen beigebracht und an den Stellen (9.21, 9.21') der vorgesehenen Konturöffnungen (21) das Substrat (4) freigelegt wird,
c) Abtragen von elektrisch isolierendem Material des Substrates (4) mit einem Ätzprozess an den Stellen, an denen das Substrat (4) frei liegt,
**dadurch gekennzeichnet, dass**
das Substrat (4) an den Stellen (9.21, 9.21') der vorgesehenen Konturöffnungen im Schritt b) beidseitig freigelegt wird, **dass**
im Schritt c) mindestens an den Stellen (9.21, 9.21') der vorgesehenen Konturöffnungen beidseitig Material abgetragen wird, und **dass**
im Schritt c) so lange elektrisch isolierendes Material vom Substrat (4) abgetragen wird, bis die entstandenen Konturöffungen (21) durchgehend sind.

2. Verfahren gemäss Anspruch 1, **dadurch gekennzeichnet, dass** der Schritt c) durch Plasmaätzen erfolgt.

3. Verfahren gemäss Anspruch 1 oder 2, **dadurch gekennzeichnet, dass** mehrere Konturöffnungen (21) beigebracht werden, welche eine vorgegebene Konturlinie des herzustellenden Produktes begrenzen und durch nachträglich durchtrennbare Verbindungsstege (22) unterbrochen sind.

4. Verfahren gemäss Anspruch 3, **dadurch gekennzeichnet, dass** anschliessend die Verbindungsstege (22) durchtrennt werden, wodurch ein Produkt mit mindestens teilweise durch die Konturlinie gegebenen Konturen (K) entsteht.

5. Verfahren nach einem der Ansprüche 1 bis 4, **dadurch gekennzeichnet, dass** gleichzeitig mit den Konturöffungen (21) auch z-Verbindungen geätzt werden.

6. Verfahren nach einem der Ansprüche 1 bis 5, **dadurch gekennzeichnet, dass** die schaltungsrelevanten Strukturen ein in den leitenden Schichten (7, 8) ausgebildetes Leiterbild (L) umfassen, und dass vorgängig zum Schritt c) beidseitig Schablonen (23, 23') aufgepresst werden, welche Öffnungen (23.21, 23.21') an den Stellen der vorgesehenen Konturöffnungen (21) aufweisen.

7. Verfahren nach Anspruch 6, **dadurch gekennzeichnet, dass** nach dem Verfahrensschritt b) und vor dem Aufpressen der Schablonen auf die aussenliegenden strukturierten Leiterebenen mindestens einmal ein oder beidseitig weitere Folienlagen mit aussenliegenden leitenden Schichten auflaminiert und zu weiteren Leiterebenen mit Durchführungen zu inneren Leiterebenen strukturiert werden, wobei in allen zusätzlichen Folienlagen in den Bereichen der vorgesehenen Konturöffnungen die leitenden Schichten entfernt werden.

8. Halbzeug für die Herstellung einer Leiterplatte oder Folienleiterplatte, herstellbar nach einem Verfahren nach einem der Ansprüche 1 bis 7, aufweisend ein platten- oder folienförmiges Substrat (4) mit einer oder mehreren elektrisch isolierenden Schichten sowie strukturierte, elektrisch leitende Schichten (7, 8), wobei das Substrat mit Konturöffnungen (21) für eine Strukturierung der äusseren Form der Leiterplatte oder Folienleiterplatte versehen ist, welche durch Abtragen von elektrisch isolierendem Material mit einem chemischen Ätzprozess erzeugt worden sind,
**dadurch gekennzeichnet, dass**
das Substrat (4) an den Stellen (9.21, 9.21') der vorgesehenen Konturöffnungen im Schritt b) beidseitig freigelegt ist, und dass die Konturöffnungen (21) durchgehend und durch Abtragen von elektrisch isolierendem Material von beiden Seiten her erzeugt sind.

9. Leiterplatte oder Folienleiterplatte, hergestellt aus einem Halbzeug nach Anspruch 8, aufweisend mindestens eine elektrisch isolierende Schicht als Substrat (4), welche mindestens einseitig eine Leiterebene (7, 8) mit einem Leiterbild (L) trägt,
**dadurch gekennzeichnet, dass**
ihre äussere Form durch eine Kontur (K) begrenzt ist, welche mindestens teilweise dadurch erzeugt ist, dass einem platten- oder folienförmigen, beidseitig mit Leitermaterial (7, 8) versehenen Substrat (4) mit durchgehenden, lateral durch Verbindungsstege (22) getrennte und durch Abtragen von elektrisch isolierendem Material von beiden Seiten her erzeugte Konturöffnungen (21), beigebracht wurden und die Verbindungsstege anschliessend durchtrennt wurden.

## Claims

1. Method for the manufacture of circuit boards, foil circuit boards, semifinished products for circuit boards, with structured electrically conductive layers and with contour openings (21) for a structuring of the outer form, comprising the steps:
a) providing of a substrate (4) in board- or foil-form comprising one or several electrically insulated layers, which substrate (4) is equipped with a conducting layer (7, 8) on both sides,
b) structuring of the conductive layers (7, 8) by partial removal of conductive material, wherein simultaneously circuit-relevant structures are created and in the locations (9.21, 9.21') of the intended contour openings (21) the substrate (4) is exposed,
c) removal of electrically conductive material of the substrate (4) with an etching process in the locations in which the substrate (4) is exposed,
**characterized in that**
in step b) the substrate (4) is exposed in the locations (9.21, 9.21') of the intended contour openings on both sides, that
in step c) at least in the locations (9.21, 9.21') of the intended contour openings material is removed on both sides, and that
in step c), electrically insulating material is removed from the substrate (4) until the created contour openings (21) reach right through.

2. Method according to claim 1, **characterized in that** the step c) is carried out by means of plasma etching.

3. Method according to claim 1 or 2, **characterized in that** several contour openings (21) are created, which limit a predetermined contour line of the product to be manufactured and are interrupted by subsequently separable connecting webs (22).

4. Method according to claim 3, **characterized in that** the connecting webs (22) are subsequently separated, by which a product with contours (K) determined at least partly by the contour line is formed.

5. Method according to one of claims 1 to 4, **characterized in that** simultaneously to the contour openings (21) z-connections are etched.

6. Method according to one of claims 1 to 5, **characterized in that** the circuit-relevant structures comprise a conductor pattern (L) formed in the conductive layers (7,8) and that before step c) stencils (23, 23') are pressed onto both sides which stencils comprise openings (23.21, 23.21') in the locations of the intended contour openings (21).

7. Method according to claim 6, **characterized in that** after method step b) and before the pressing of the stencils onto the outer structured conductor surfaces further foil layers are laminated on to one side or both at least once and are structured to form further conductor surfaces with through holes to the inner conductor surfaces, wherein in all additional foil layer the conductor layer is removed in the regions of the intended contour openings.

8. Semifinished product for the manufacture of a circuit board or foil circuit board, manufacturable according to one of claims 1 to 7, comprising a substrate (4) in board- or foil-form with one or several electrically insulating layers as well as structured, electrically conductive layers (7, 8), wherein the substrate is equipped with contour openings (21) for a structuring of the outer form of the circuit board or foil circuit board, which has been created by removal of electrically insulating material in a chemical etching process,
**characterized in that**
the substrate (4) is, in the locations (9.21, 9.21') of the intended contour openings, (21) laid open on both sides in step b) and that the contour openings (21) reach right through and are created by means of removal of electrically insulating material from both sides.

9. Circuit board or foil circuit board, manufactured from a semifinished product according to claim 8, comprising at least one electrically conductive layer as substrate (4), which, at least on one side carries a conductor surface (7, 8) with a conductor pattern (L),
**characterized in that**
their outer form is limited by a contour (K), which is at least partly formed by means of creating contour openings (21) in a substrate (4) in board- or foil-form, equipped with conductor material (7, 8) on both sides, which openings reach right through and are laterally separated by connecting webs (22) and are created by removal of electrically insulating material from both sides and the connecting webs are subsequently separated.

## Revendications

1. Procédé pour la préparation de circuits imprimés, de feuilles de circuit imprimé, de produits semi-finis pour des circuits imprimés et de produits semi-finis pour des feuilles de circuit imprimé qui présentent des couches électriquement conductrices structurées et des ouvertures de contour (21) pour une structuration de la forme extérieure, lequel procédé comportant les étapes qui consistent à:
a) prévoir un substrat (4) en forme de plaque ou de feuille qui présente une ou plusieurs couches électriquement isolantes et qui est doté sur ses deux faces d'une couche conductrice (7, 8),
b) structurer les couches conductrices (7, 8) par enlèvement partiel de matériau conducteur, des structures de circuit étant apportées simultanément et le substrat (4) étant libéré aux emplacements (9.21, 9.21') des ouvertures de contour (21) prévues,
c) enlever le matériau électriquement isolant du substrat (4) par un procédé de gravure aux endroits auxquels le substrat (4) est libéré,
**caractérisé en ce que**
à l'étape b), le substrat (4) est libéré sur les deux côtés aux emplacements (9.21, 9.21') des ouvertures de contour prévues,
**en ce qu'**à l'étape c), le matériau est enlevé sur les deux côtés aux emplacements (9.21, 9.21') des ouvertures de contour prévues, et
**en ce qu'**à l'étape c), le matériau électriquement isolant du substrat (4) est enlevé jusqu'à ce que les ouvertures de contour (21) obtenues soient continues.

2. Procédé selon la revendication 1, **caractérisé en ce que** l'étape c) est réalisée par gravure au plasma.

3. Procédé selon la revendication 1 ou 2, **caractérisé en ce que** plusieurs ouvertures de contour (21) sont installées, délimitent une ligne de contour prévue pour le produit à fabriquer et sont interrompues par des passages de liaison (22) qui peuvent être séparés ultérieurement.

4. Procédé selon la revendication 3, **caractérisé en ce qu'**ensuite, les parcours de liaison (22) sont séparés, ce qui permet d'obtenir un produit qui présente des contours (K) définis au moins en partie par la ligne de contour.

5. Procédé selon l'une des revendications 1 à 4, **caractérisé en ce que** des liaisons suivant l'axe z sont également gravées en même temps que les ouvertures de contour (21).

6. Procédé selon l'une des revendications 1 à 5, **caractérisé en ce que** les structures de circuit comprennent un motif conducteur (L) réalisé dans les deux couches (7, 8) et **en ce qu'**avant l'étape c), des motifs (23, 23') qui présentent des ouvertures aux emplacements des ouvertures de contour (21) prévues sont appliqués des deux côtés par pression.

7. Procédé selon la revendication 6, **caractérisé en ce qu'**après l'étape de traitement b) et avant l'application par pression des motifs sur les plans conducteurs structurés situés à l'extérieur, une ou d'autres couches de feuilles dotées de couches conductrices extérieures sont stratifiées au moins une fois des deux côtés et sont structurées en autres plans conducteurs dotés de passages vers les plans conducteurs intérieurs, les couches conductrices étant enlevées dans les zones des ouvertures de contour prévues dans toutes les couches de feuille supplémentaires.

8. Produit semi-fini pour la préparation d'une plaque de circuit imprimé ou d'une feuille de circuit imprimé qui peuvent être préparées par un procédé selon l'une des revendications 1 à 7, qui présente un substrat (4) en forme de plaque ou de feuille doté d'une ou de plusieurs couches électriquement isolantes ainsi que des couches électriquement conductrices (7, 8) structurées, le substrat étant doté d'ouvertures de contour (21) pour une structuration de la forme extérieure de la plaque de circuit imprimé ou de la feuille de circuit imprimé, lesquelles ouvertures de contour ont été créées par enlèvement du matériau électriquement isolant par une opération de gravure chimique,
**caractérisé en ce que**
à l'étape b), le substrat (4) est libéré sur les deux côtés aux emplacements (9.21, 9.21') des ouvertures de contour prévues et **en ce que** les ouvertures de contour (21) sont continues et sont créées des deux côtés et par enlèvement du matériau électriquement isolant.

9. Plaque de circuit imprimé ou feuille de circuit imprimé préparées à partir d'un produit semi-fini selon la revendication 8, qui présente comme substrat (4) au moins une couche électriquement isolante qui porte sur au moins un côté un plan conducteur (7, 8) doté d'un motif conducteur (L),
**caractérisé en ce que**
sa forme extérieure est délimitée par un contour (K) qui est créé au moins en partie en apportant sur un substrat (4) en forme de plaque ou de feuille, doté des deux côtés d'un matériau conducteur (7, 8), des ouvertures de contour (21) continues, séparées latéralement par des passages de liaison (22) et créées par enlèvement du matériau électriquement conducteur sur les deux côtés, les passages de liaison étant ensuite séparés.
